# EUROPEAN PATENT SPECIFICATION

(11) **EP 3 754 428 B1**
(45) Date of publication and mention of the grant of the patent: **17.04.2024**
(21) Application number: 19776974.8
(22) Date of filing: 20.02.2019
(51) Int. Cl.: G03F 7/30, B41C 1/10

(54) **DEVELOPMENT PROCESSING DEVICE FOR PLANOGRAPHIC PRINTING PLATE MANUFACTURE, AND MANUFACTURING METHOD OF PLANOGRAPHIC PRINTING PLATE**
ENTWICKLUNGSVERARBEITUNGSVORRICHTUNG FÜR FLACHDRUCKPLATTENHERSTELLUNG UND VERFAHREN ZUR HERSTELLUNG EINER FLACHDRUCKPLATTE
DISPOSITIF DE TRAITEMENT DE DÉVELOPPEMENT POUR LA FABRICATION DE PLAQUES D'IMPRESSION PLANOGRAPHIQUE ET PROCÉDÉ DE FABRICATION DE PLAQUES D'IMPRESSION PLANOGRAPHIQUE

(30) Priority: 29.03.2018 JP 2018065222; 06.02.2019 JP 2019019576
(43) Date of publication of application: 23.12.2020
(73) Proprietor: FUJIFILM Corporation, Tokyo 106-8620 (JP)
(72) Inventor: SATO, Takashi, Haibara-gun, Shizuoka 421-0396 (JP); WATANABE, Toshihiro, Haibara-gun, Shizuoka 421-0396 (JP); TANAKA, Hideyuki, Haibara-gun, Shizuoka 421-0396 (JP)
(74) Representative: Hoffmann Eitle
(86) International application number: PCT/JP2019/006389
(87) International publication number: WO 2019/187818

(56) References cited:
- EP-A1- 1 298 495
- EP-A2- 1 437 626
- JP-A- H03 107 950
- JP-A- H05 265 225
- JP-A- H08 123 039
- JP-A- 2001 281 885
- JP-A- 2006 235 227
- US-A1- 2004 060 466

## Description

The present disclosure relates to a development processing apparatus for producing a lithographic printing plate, and a method for producing a lithographic printing plate.

A lithographic printing plate typically consists of a lipophilic image area which receives ink and a hydrophilic non-image area which receives dampening water, in the printing process.

Lithographic printing is a method of printing an image by setting a lipophilic image area of a lithographic printing plate as an ink receiving area and a hydrophilic non-image area of the lithographic printing plate as a dampening water receiving area (ink non-receiving area) using the property in which water and oily ink repel each other, causing a difference in adhesiveness of ink to the surface of the lithographic printing plate, allowing the ink to be impressed only on an image area, and transferring the ink to a printing medium such as paper.

Currently, in a plate-making step of producing a lithographic printing plate from a lithographic printing plate precursor, image exposure has been performed using a computer-to-plate (CTP) technology. That is, the image exposure is performed by directly scanning and exposing a lithographic printing plate precursor using a laser or a laser diode without using a lith film.

As a development processing apparatus of the related art, development processing apparatuses described in Each of JP 2006 235227 A; US 2004/060466 A1; EP 1 298 495 A1; EP 1 437 626 A2; JP H08 123039 A; JP H03 107950 A; JP H05 265225 A; and JP 2001 281885 A forms part of the state of the art relative to the present disclosure. Patent document 1 or JP2005-258281A hereinafter Patent Document 2 has been known.

WO2017/157570A hereinafter

The present inventors have found that the following objects occur in a processing method of a printing plate precursor using an apparatus for continuously performing gum treatment after development, which is the development processing apparatus of the related art.

In the lithographic printing plate precursor, since a developer, for example, a high pH alkaline developer, adheres to the plate after passing through a development treatment section, dissolution of a photosensitive layer is not completely stopped. Thereafter, a low pH gum solution is supplied to the plate in a gum treatment section to neutralize the developer, and the dissolution of the photosensitive layer is completely stopped.

In a case where the development processing is completed (stopped), since the gum solution is not supplied for a long time, moisture in the gum solution adhered to a transport roller evaporates, and a stuck gum component or high-concentration gum solution remains on the transport roller.

Therefore, in a case where the gum solution is supplied again on the roller to restart the processing, the high-concentration gum solution or the stuck gum component remains on the roller immediately after the processing is restarted. In this case, the concentration of the gum solution on the roller of the gum treatment section is increased due to the evaporation of moisture, and a gum solution having a lower pH is partially generated on the roller. As a result, since a portion where the gum solution component having a lower pH remains is neutralized and the development is stopped quickly, there has been a problem that unevenness occurs in halftone dot reproducibility or printing durability of halftone dots in a case of printing the obtained lithographic printing plate.

In addition, since an alkaline developer in which components, such as an alkalisoluble resin, constituting the lithographic printing plate precursor are dissolved adheres to the plate and is brought into the gum solution in the gum treatment section, which has a low pH, in a case where these components are accumulated, the components tend to be precipitated as scum in a case where moisture evaporates on the roller and the concentration is high. Since these precipitates damage a surface of the roller or adhere to the lithographic printing plate, which greatly deteriorates the quality of the lithographic printing plate, there has been a problem that unevenness occurs in halftone dot reproducibility or printing durability of halftone dots.

An object to be achieved by an embodiment of the present invention is to provide a development processing apparatus for producing a lithographic printing plate, which has excellent halftone dot reproducibility in a case of printing the obtained lithographic printing plate and suppresses the occurrence of unevenness in printing durability of halftone dots.

An object to be achieved by another embodiment of the present invention is to provide a method for producing a lithographic printing plate using the development processing apparatus for producing a lithographic printing plate.

According to a first aspect of the present invention, there is provided a development processing apparatus as recited in claim 1 below.
According to a second aspect of the present invention, there is provided a method of producing a lithographic printing plate as recited in claim 9 below.
The dependent claims are directed to particular embodiments and implementations of each respective aspect.

With embodiments of the invention in the first aspect, it is possible to provide a development processing apparatus for producing a lithographic printing plate, which has excellent halftone dot reproducibility in a case of printing the obtained lithographic printing plate and suppresses occurrence of unevenness in printing durability of halftone dots.

In addition, with implementations of the invention in the second aspect, it is possible to provide a method for producing a lithographic printing plate obtained by using the development processing apparatus for producing a lithographic printing plate.

### BRIEF DESCRIPTION OF THE DRAWINGS

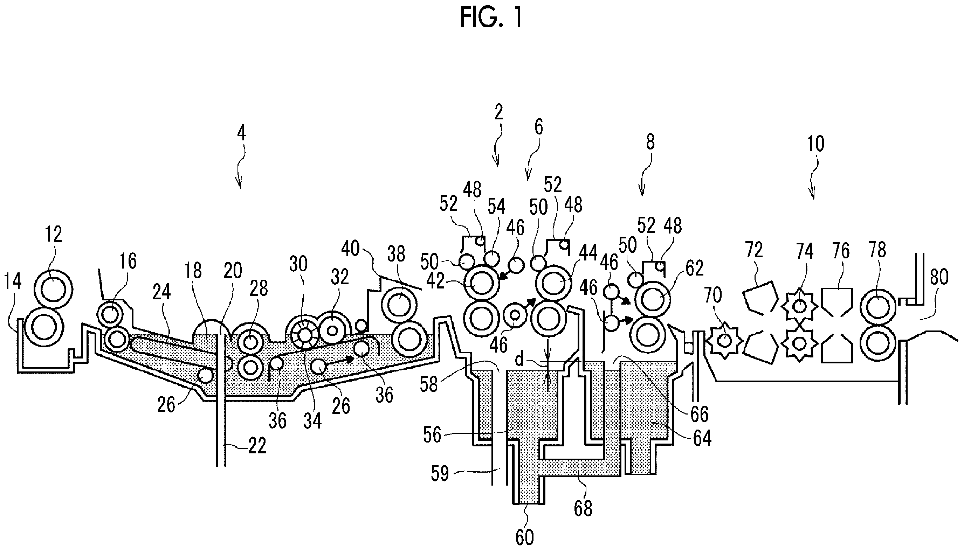

Fig. 1 is a schematic cross-sectional view showing an example of a development processing apparatus for producing a lithographic printing plate according to the present embodiment.

Hereinafter, the contents of the present disclosure will be described in detail. The description of constituent elements below is made based on representative embodiments of the present disclosure in some cases, but the present disclosure is not limited to such embodiments. The present invention is limited by the scope of the claims, only.

In the present specification, the numerical ranges shown using "to" indicate ranges including the numerical values described before and after "to" as a lower limit value and an upper limit value.

In numerical ranges described in stages in the present specification, an upper limit value or a lower limit value described in one numerical range may be replaced with an upper limit value or a lower limit value of a numerical range described in another stage. In addition, in the numerical ranges described in the present specification, the upper limit value or the lower limit value of the numerical ranges may be replaced with the values shown in examples.

In addition, in a case where substitution or unsubstitution is not noted in regard to the notation of a "group" (atomic group) in the present specification, the "group" includes not only a group not having a substituent but also a group having a substituent. For example, the concept of an "alkyl group" includes not only an alkyl group not having a substituent (unsubstituted alkyl group) but also an alkyl group having a substituent (substituted alkyl group).

In the present specification, the concept of "(meth)acryl" includes both of acryl and methacryl, and the concept of"(meth)acryloyl" includes both of acryloyl and methacryloyl.

In addition, the term "step" in the present specification indicates not only an independent step but also a step which cannot be clearly distinguished from other steps as long as the intended purpose of the step is achieved.

In addition, in the present disclosure, "% by mass" has the same definition as that for "% by weight", and "part by mass" has the same definition as that for "part by weight".

Furthermore, in the present disclosure, a combination of two or more preferred aspects is a more preferred aspect.

In addition, the weight-average molecular weight (Mw) and the number-average molecular weight (Mn) in the present disclosure are molecular weights in terms of polystyrene used as a standard substance, which are detected by using a solvent tetrahydrofuran (THF), a differential refractometer, and a gel permeation chromatography (GPC) analyzer using TSKgel GMHxL, TSKgel G4000HxL, and TSKgel G2000HxL (all trade names manufactured by Tosoh Corporation) as columns, unless otherwise specified.

In the present specification, the term "lithographic printing plate precursor" includes not only a lithographic printing plate precursor but also a key plate precursor. In addition, the term "lithographic printing plate" includes not only a lithographic printing plate produced by performing operations such as exposure and development, on a lithographic printing plate precursor as necessary but also a key plate. In a case of the key plate precursor, operations of exposure and development are not necessarily required. In addition, a key plate is a lithographic printing plate precursor for attachment to a plate cylinder which is not used, for example, in a case where printing is performed on a part of a paper surface with one or two colors in color newspaper printing.

Hereinafter, the present disclosure will be described in detail.

### (Development processing apparatus for producing lithographic printing plate)

The development processing apparatus for producing a lithographic printing plate (hereinafter, also simply referred to as a "development processing apparatus") according to an embodiment of the present disclosure includes a development section and a gum treatment section continuous to the development section, in which the gum treatment section has a transport roller, and a unit A supplying a washing solution to the transport roller.

In addition, the development processing apparatus according to the embodiment of the present disclosure is preferably an automatic development processing apparatus.

Most of development processing apparatuses of the related art have a water washing section continuous to a development section and further have a gum treatment section, and in a processing method of a lithographic printing plate precursor using an apparatus for continuously performing gum treatment after development in the related art, as described above, there has been a problem that unevenness occurs in halftone dot reproducibility or printing durability of halftone dots in the obtained lithographic printing plate.

As a result of intensive studies conducted by the present inventors, it is found that, by employing the above-described configuration, it is possible to provide a development processing apparatus for producing a lithographic printing plate, which has excellent halftone dot reproducibility in a case of printing the obtained lithographic printing plate and suppresses occurrence of unevenness in printing durability of halftone dots.

The mechanism of the excellent effects obtained by employing the above-described configuration is not clear, but is assumed as follows.

As described above, the present inventors have found that the development processing apparatus including a development section and a gum treatment section continuous to the development section, the gum treatment section has a transport roller, and a unit A supplying a washing solution to the transport roller, the stuck gum component or the high-concentration gum solution, which is considered to be present on the transport roller, is dissolved or diluted by the washing solution supplied from the unit A. Therefore, it is assumed that development unevenness can be suppressed, the obtained lithographic printing plate has excellent halftone dot reproducibility in a case of printing, and the occurrence of unevenness in printing durability of halftone dots is suppressed.

Hereinafter, the embodiment of the present disclosure will be described in detail with reference to the drawing.

Fig. 1 is a schematic cross-sectional view of an example of the development processing apparatus according to the embodiment of the present disclosure.

A development processing apparatus 2 shown in Fig. 1 has a development section 4, a gum treatment section 6 continuous to the development section 4, a second gum treatment section 8 continuous to the gum treatment section 6, and a drying section 10.

The development processing apparatus according to the embodiment of the present disclosure is not limited to the structure shown in Fig. 1, and any development apparatus exhibiting all essential elements of the inventive apparatus as defined by the appended claims can be applied.

The development processing apparatus according to the embodiment of the present disclosure has the second gum treatment section 8 continuous to the gum treatment section 6,

In addition, the development processing apparatus according to the embodiment of the present disclosure may have or may not have the drying section 10, and for example, a lithographic printing plate producing system which has a drying device in addition to the development processing apparatus according to the embodiment of the present disclosure may be used.

In the development processing apparatus 2 shown in Fig. 1, a development treatment of a lithographic printing plate precursor exposed by an exposure device not shown in the drawing is performed. Here, the exposure device is not particularly limited, and a known exposure device can be used.

The active energy ray used for the exposure is not particularly limited as long as the active energy ray is used for the exposure of the lithographic printing plate precursor, and preferred examples thereof include infrared ray and ultraviolet ray.

As a light source of the active energy ray used for the exposure, a light source having an emission wavelength from near-infrared region to infrared region is preferable, and a solid-state laser or a semiconductor laser is more preferable. Among these, in the present disclosure, it is particularly preferable that image exposure is performed by a solid-state laser or a semiconductor laser which emits infrared ray having a wavelength of 750 nm to 1,400 nm.

The output of the laser is preferably 100 mW or more, and for the purpose of reducing the exposure time, it is preferable to use a multi-beam laser device. In addition, the exposure time per one pixel is preferably within 20 µsec.

The energy irradiated to the lithographic printing plate precursor is preferably in a range of 10 mJ/cm² to 300 mJ/cm². With the above-described range, curing can be sufficiently proceeded, laser ablation can be suppressed, and damage to an image can be prevented.

In addition, the exposure can be performed by overlapping light beams of light sources. The overlap refers to that the sub-scanning pitch width is smaller than the beam size. For example, in a case where the beam size is expressed in terms of full width at half maximum (FWHM) of the beam intensity, the overlap can be quantitatively expressed by FWHM/sub-scanning pitch width (overlap coefficient). The overlap coefficient is preferably 0.1 or more.

The scanning system of the light source in the exposure device is not particularly limited, and a cylinder external surface scanning system, a cylinder internal surface scanning system, a planar scanning system, and the like can be used. In addition, the channel of the light source may be a single channel or a multi-channel, but in a case of a cylinder external surface scanning system, a multi-channel is preferably used.

The lithographic printing plate precursor developed by the development processing apparatus according to the embodiment of the present disclosure is not particularly limited, and a known positive or negative lithographic printing plate precursor can be used.

Among these, from the viewpoint that the effect of halftone dot reproducibility and suppression of unevenness in printing durability of halftone dots is further exhibited, a positive lithographic printing plate precursor (not shown) with a developer 18, the gum treatment section 6 and second gum treatment section 8 for desensitizing the developed lithographic printing plate precursor (not shown) by applying gum solutions 56 and 64 to protect a plate surface, the drying section 10 for drying the gum-treated lithographic printing plate precursor (lithographic printing plate, not shown) are provided. That is, in the development processing apparatus 2, the development section 4, the gum treatment section 6, the second gum treatment section 8, and the drying section 10 are arranged in order along a transport direction (direction from the left side to the right side in Fig. 1) of the lithographic printing plate precursor.

The exposed lithographic printing plate precursor (not shown) is transported to the development section 4 by a transport roller 12 composed of one pair of two rollers.

The exemplary development processing apparatus 2 shown in Fig. 1 has, in addition to a wall assembly 14, a housing (not shown) which covers at least the upper part of the development section 4, gum treatment section 6, second gum treatment section 8, drying section 10, and the housing.

The shapes of the wall assembly 14 and the housing are not particularly limited, and may be appropriately selected as necessary. In addition, the materials of the wall assembly 14 and the housing are not particularly limited, and known materials can be used.

The development section 4 has transport rollers 16, 28, and 38, each of which is composed of one pair of two rollers, a developer 18, a developer exhausting unit 22 having a developer exhausting port 20, a transport belt 24, a developer supplying unit 26, a brush roller 30, a transport roller 32, a transport guide board 34, a transport guide board holding member 36, and a cover 40.

In addition, the development section 4 has a substantial mountain shape in which a center of a bottom part protrudes downward, and stores the developer 18 used for performing a development treatment of the exposed lithographic printing plate precursor (not shown).

For example, in a case of driving the transport roller 16 to rotate, while being drawn into the development section 4, the exposed lithographic printing plate precursor (not shown) is fed into the developer 18 at an angle of approximately 15° to 31° with respect to a horizontal direction.

The temperature of the developer 18 is not particularly limited, but is preferably in a range of 0°C to 60°C and more preferably in a range of 15°C to 40°C.

The details of the developer 18 suitably used in the present disclosure will be described later.

The exposed lithographic printing plate precursor (not shown) is transported by the transport roller 16, is immersed in the developer 18, passes through on the transport belt 24, the transport roller 28, the transport guide board 34, and the transport roller 38 in order, and is transported to the gum treatment section 6.

In the development section 4, the exposed lithographic printing plate precursor (not shown) is immersed in the developer 18 so as to be developed, and in the developer 18, the brush roller 30 rubs the plate surface of the lithographic printing plate precursor so as to promote the development. Furthermore, in a case where the lithographic printing plate precursor passes through the transport roller 38, the developer 18 adhering to the developed lithographic printing plate precursor is partially squeezed and removed.

In addition, in the development section 4, a new developer 18 is supplied from the developer supplying unit 26, and for example, the developer supplying unit 26 discharges the developer 18 in a direction of the arrow shown in the developer supplying unit 26 on the right side of Fig. 1.

The developer 18 may be supplied by the developer supplying unit 26 continuously or intermittently, and can be supplied as necessary. In addition, a supply direction of the developer 18 is not particularly limited, and the developer 18 may be discharged so as to hit the lithographic printing plate precursor or may be supplied so that an intentional flow does not occur.

The development section 4 is filled with the developer 18 to a certain height (height of the developer exhausting port 20). In addition, a space not filled with the developer 18 is provided above the developer exhausting port 20, and the developer 18 exceeding the height of the developer exhausting port 20 passes through the developer exhausting port 20 and is exhausted by the developer exhausting unit 22.

The shapes of the developer exhausting port 20 and the developer exhausting unit 22 are not particularly limited, and preferred examples thereof include a pipe shape as shown in Fig. 1.

Thus, Fig. 1 illustrates an example of the development section 4 in the present disclosure, but it is needless to say that the development section 4 is not limited thereto.

The gum treatment section 6 is provided continuously to the development section 4.

The term "continuous" in the present disclosure means an aspect in which, without performing other treatments (for example, water washing treatment and the like) between the development by the development section 4 and a gum treatment by the gum treatment section 6, the development and the gum treatment are performed, and the positions of the development section 4 and the gum treatment section 6 and the distance thereof are not particularly limited and may be set appropriately.

In addition, in at least a part of the gum treatment section 6, preferably in a portion continuous from the development section 4, it is preferable that a transport position of the developed lithographic printing plate precursor is higher than the liquid level of the developer 18 in the development section 4. According to the above-described aspect, it is possible to reduce the mixing of the developer 18 with the gum solution 56 in the gum treatment section 6.

The gum treatment section 6 has transport rollers 42 and 44, each of which is composed of one pair of two rollers, a gum solution supplying spray 46, a unit 48 (unit A) dropping a washing solution, a washing solution spreading member 50, a washing solution supplying unit fixing part 52, a backflow preventing member 54, a gum solution 56, and a gum solution exhausting unit 59 having a gum solution exhausting port 58.

The developed lithographic printing plate precursor (not shown) is transported from the development section 4, is subjected to, between the transport roller 42 and the transport roller 44, a gum treatment on both the upper surface and lower surface of the lithographic printing plate precursor by upper and lower gum solution supplying sprays 46, and is transported to the second gum treatment section 8.

The upper gum solution supplying spray 46 in Fig. 1 sprays the gum solution 56 toward an upper roller of the transport roller 42 composed of two rollers.

In addition, the lower gum solution supplying spray 46 in Fig. 1 sprays the gum solution 56 toward the lower surface of the lithographic printing plate precursor.

In addition, in the gum treatment section 6, an aspect in which the gum solution is supplied to the upper surface of the lithographic printing plate precursor at a position upstream of at least one pair of transport rollers (for example, the transport roller 44) in the transport direction, is accumulated on the lithographic printing plate precursor, and neutralizes and washes the developer is preferably exemplified.

Furthermore, the gum treatment section 6 has two pairs of transport rollers 42 and 44 including the transport roller, and it is preferable that, between one pair of transport roller 42 on an upstream side in the transport direction and one pair of transport roller 44 on a downstream side in the transport direction, a unit (upper side 46), which supplies the gum solution 56 to the plate surface of the developed lithographic printing plate directly or through the one pair of transport roller 44 on the upstream side in the transport direction, is provided in the gum treatment section. According to the above-described aspect, since the gum solution 56 is accumulated between the two pairs of the transport rollers 42 and 44, the gum treatment is performed without unevenness, and halftone dot reproducibility and suppression property of unevenness in printing durability of halftone dots are more excellent.

A discharge direction of the gum solution 56 by the gum solution supplying spray 46 in the present disclosure is not particularly limited, the respective aspects shown in Fig. 1 are preferably exemplified.

The excess gum solution 56 is stored in a lower part of the gum treatment section 6.

The gum solution 56 discharged toward the roller by the upper gum solution supplying spray 46 in Fig. 1 moves to the upper part of the roller as the roller rotates, and by providing the backflow preventing member 54, it is possible to prevent the gum solution 56 from being mixed with the developer 18 in the development section 4 through the lithographic printing plate precursor.

The shape of the backflow preventing member 54 is not particularly limited, but is preferably cylindrical or blade-shape. In addition, it is preferable that the backflow preventing member 54 is provided in contact with the transport roller 42. Furthermore, it is preferable that, in a direction of rotation of the contact roller, the backflow preventing member 54 is provided at an upstream side of a position of supplying the washing solution from the unit A (unit 48 dropping a washing solution) onto the roller, and an upstream side of the washing solution spreading member 50.

That is, in the transport roller 42, it is preferable that, from a downstream side of the direction of rotation, the washing solution spreading member 50, the position of supplying the washing solution from the unit A (unit 48 dropping a washing solution) onto the roller, the backflow preventing member 54 are provided in this order.

In addition, from the viewpoint of suppressing the inflow of the gum solution into the development section, it is preferable that the width of the backflow preventing member 54 in an axial direction of the roller is larger than the width of the roller.

The gum treatment section 6 has the transport roller 42, and the unit A (unit 48 dropping a washing solution) supplying a washing solution to the transport roller 42.

It is preferable that the unit A is the unit 48 installed above the transport roller 42 in the gum treatment section 6 and dropping a washing solution onto the transport roller 42.

The washing solution may be supplied by the unit A in a form of spray, but it is preferable that the washing solution is dropped.

The unit 48 dropping a washing solution is fixed by the washing solution supplying unit fixing part 52, and drops the washing solution on the upper roller of the transport roller 42. In addition, the washing solution spreading member 50 is installed in contact with an outer periphery of an upper roller of the transport roller on a development section 4 side (downstream side of the upper roller) from a position where the washing solution is dropped from the unit 48 dropping a washing solution on the upper roller of the transport roller 42, and above a center of an axis of the upper roller.

The washing solution spreading member 50 is a member which is provided on the transport roller 42 in the gum treatment section 6, and spreads the washing solution dropped on the transport roller 42 onto the transport roller 42.

The washing solution spreading member 50 has a function in which a washing water supplied from the unit A supplying the washing water to the upper roller in the gum treatment section 6 is uniformly spread on a peripheral surface of the upper roller, and the gum solution 56 is washed off from the peripheral surface of the upper and lower rollers of the transport roller 42. Thereby, the gum solution remaining on the transport roller 42 is uniformly removed before the processing is stopped, so that, after the processing is stopped, the concentration of the gum component on the transport roller 42 is prevented from being high or the gum component is prevented from sticking.

In order to form a solution pool between the washing solution spreading member 50 and the upper roller, and to prevent the washing water from overflowing from a bar or a blade to any place other than the roller, it is preferably that the washing solution spreading member 50 is in contact with the roller at a position above a rotation axis of the upper roller.

The shape of the washing solution spreading member 50 is preferably a cylindrical bar or a board-shaped blade, and more preferably a cylindrical bar.

In a case where the washing solution spreading member 50 is a cylindrical member, a metal bar formed of stainless steel and the like, a rubber roller, or a resin roller is preferable. In addition, a cylindrical washing water spreading bar may follow the rotation of the roller in contact with the bar, may be fixed, or may be rotated by a drive shaft.

In a case where the washing solution spreading member 50 is a board-shaped and blade-shaped member, suitable examples of a material of the washing solution spreading member 50 include rubber, resin, and metal, a material which is flexible and does not damage the surface of the roller in contact with the washing solution spreading member 50 is preferable, and a flexible rubber board or a flexible resin board is more preferable.

The shape of the washing solution supplying unit fixing part 52 is not particularly limited, but as shown in Fig. 1, is preferably a shape in which a cross-sectional shape covers at least three sides of the unit 48 dropping a washing solution.

In addition, the washing solution discharged from the unit 48 dropping a washing solution may be directly supplied to the roller, or may be flowed onto the roller through a wall surface or the like of the washing solution supplying unit fixing part 52 after being discharged.

The washing solution dropped on the upper roller from the unit 48 dropping a washing solution is spread in an axial direction of the upper roller by the washing solution spreading member 50, the washing solution is supplied to the upper roller and the lower roller, and the stuck gum component or the high-concentration gum solution, which is considered to be present on the transport roller 42, can be dissolved or diluted by the washing solution.

In addition, since each roller of the transport roller 42 is rotated, the washing solution can be supplied to the entire surface of each roller.

The washing solution flowing down from the transport roller 42 mixes with the gum solution 56.

The temperature and the amount of the washing solution and gum solution 56 to be used are not particularly limited, and may be appropriately selected.

The details of the washing solution and gum solution 56 suitably used in the present disclosure will be described later.

The timing for supplying the washing solution from the unit A (unit 48 dropping a washing solution) supplying a washing solution, from the viewpoint of halftone dot reproducibility and suppression of unevenness in printing durability of halftone dots of the obtained lithographic printing plate, is established such that the unit A supplying a washing solution is set to supply the washing solution on the transport roller in at least one point in time selected from the group consisting of a start of operation of the development processing apparatus, a time from an end of development processing to a start of next development processing, and an end of operation of the development processing apparatus.

The method of controlling the timing of supplying the washing solution is not particularly limited, and the timing may be controlled by a known control unit such as a computer.

As the amount of the washing solution supplied is larger, washing property is excellent and the stuck gum component is easily removed, but the amount of gum waste solution increases. In addition, as the amount of the washing solution supplied is smaller, the amount of gum waste solution decreases, but the washing speed is lowered.

In a case where the gum solution adhered to the roller and the gum solution component stuck to the roller can be washed by the washing, a certain amount of washing solution may be supplied continuously or intermittently. In addition, in a case of supplying the washing solution intermittently, the washing solution may be supplied only once to a plate surface of the lithographic printing plate precursor, or may be supplied in a plurality of times at intervals.

The amount of the washing solution supplied is not particularly limited because the amount of the washing solution supplied depends on the width of the development processing apparatus and components of the gum solution, and further depends on the supply method. However, in a case of supplying the washing solution intermittently, the amount of the washing solution supplied, per one supply of the washing solution, is preferably in a range of 50 mL to 1,000 mL and more preferably in a range of 100 mL to 500 mL.

In addition, from the viewpoint of efficiently washing with a small amount of washing solution, it is preferable that the washing solution is supplied in a plurality of times at intervals, which is capable of more reducing the amount of gum waste solution. For example, the washing can be preferably performed in 2 to 5 times at intervals of 10 seconds to 60 seconds.

In addition, the gum treatment section 6 has the transport roller 44, and the unit A (unit 48 dropping a washing solution) supplying a washing solution to the transport roller 44.

Aspects of the transport roller 44, the unit 48 (unit A) dropping a washing solution, which is provided in the vicinity of the transport roller 44, the washing solution spreading member 50, and the washing solution supplying unit fixing part 52 are the same as those of the transport roller 42.

The gum treatment section 6 may have or may not have the transport roller 44 which is a second transport roller, but from the viewpoint of reliability of the gum treatment and squeezing of the excess gum solution 56, it is preferable to have the transport roller 44 which is the second transport roller.

In addition, in the gum treatment section 6, an aspect in which, between the transport roller 42 and the transport roller 44, the upper surface of the lithographic printing plate precursor is covered with the gum solution supplied by the gum solution supplying spray 46 is also preferably exemplified.

It is preferable that each of the gum solutions 56 supplied from two gum solution supplying sprays 46 is a gum solution 56 collected from a bottom part 60 of the gum treatment section 6. The gum solution 56 collected from the bottom part 60 of the gum treatment section 6 is supplied to and sprayed by the gum solution supplying spray 46 through a pipe (not shown) and a pump (not shown).

In addition, the gum solutions 56 supplied from two gum solution supplying sprays 46 may be a new gum solution 56, or a gum solution 64 collected from the second gum treatment section 8.

The gum solution 56 stored in the lower part of the gum treatment section 6 fills the gum treatment section 6 to, for example, a certain height (height of the gum solution exhausting port 58). In addition, the gum solution 56 exceeding the height of the gum solution exhausting port 58 passes through the gum solution exhausting port 58, and is exhausted by the gum solution exhausting unit 59 following the gum solution exhausting port 58.

The shapes of the gum solution exhausting port 58 and the gum solution exhausting unit 59 are not particularly limited, and preferred examples thereof include a pipe shape as shown in Fig. 1.

In addition, a washing solution tank (not shown), a pipe (not shown), and a pump (not shown) are connected to the two units 48 dropping a washing solution, the two units 48 dropping a washing solution drop the washing solution supplied from the washing solution tank.

Thus, Fig. 1 illustrates an example of the gum treatment section 6 in the present disclosure, but it is needless to say that the gum treatment section 6 is not limited thereto, except that the gum treatment section 6 has the transport roller, and the unit A supplying a washing solution to the transport roller.

The second gum treatment section 8 is provided continuously to the gum treatment section 6.

The development processing apparatus according to the embodiment of the present disclosure has the second gum treatment section 8, from the viewpoint of gum treatment property and plate surface stain prevention property.

The second gum treatment section 8 has a transport roller 62 composed of one pair of two rollers, a gum solution supplying spray 46, a unit 48 (unit A2) dropping a washing solution, a washing solution spreading member 50, a washing solution supplying unit fixing part 52, a gum solution 64, and a gum solution supplying unit 68 to the gum treatment section 6, which has a gum solution exhausting port 66.

The developed lithographic printing plate precursor (not shown) is transported from the gum treatment section 6, is subjected to, in front of the transport roller 62 in the transport direction, a gum treatment on both the upper surface and lower surface of the lithographic printing plate precursor by upper and lower gum solution supplying sprays 46, and is transported to the drying section 10.

The gum solution 64 supplied from the upper and lower gum solution supplying sprays 46 in the second gum treatment section 8 circulates through a pipe (not shown) and a pump (not shown) connected to a bottom part of the second gum treatment section 8. From the viewpoint of gum treatment property and plate surface stain prevention property, it is preferable that a new gum solution (fresh gum solution) is replenished depending on the treated area.

For example, a gum solution tank (not shown), a pipe (not shown), and a pump (not shown) are connected to the upper and lower gum solution supplying sprays 46 in the second gum treatment section 8, and a new gum solution is supplied from the gum solution tank.

In addition, from the viewpoint of gum treatment property and plate surface stain prevention property, in order to correct the evaporation amount of the water depending on the treated area and the operating time, it is preferable that the second gum treatment section 8 has a unit (not shown) replenishing water. In addition, the gum treatment section 6 may have a unit replenishing water.

The gum solution 64 stored in a lower part of the second gum treatment section 8 fills the second gum treatment section 8 to, for example, a certain height (height of the gum solution exhausting port 66). In addition, the gum solution 64 exceeding the height of the gum solution exhausting port 66 (certain amount) passes through the gum solution exhausting port 66 and the gum solution supplying unit 68, and is supplied to the lower part of the gum treatment section 6.

In addition, from the viewpoint of stability in supplying the gum solution 64 to the gum treatment section 6, it is preferable that the liquid level of the gum solution 64 in the second gum treatment section 8 is higher than the liquid level of the gum solution 56 in the gum treatment section 6, and the difference d therebetween is preferably 1 cm or more, more preferably 2 cm or more, and particularly preferably 2 cm to 10 cm.

In addition, in the second gum treatment section 8, the excess gum solution 64 is squeezed by the transport roller 62, and transported to the drying section 10.

Aspects of the transport roller 62, the unit 48 (unit A) dropping a washing solution, which is provided in the vicinity of the transport roller 62, the washing solution spreading member 50, and the washing solution supplying unit fixing part 52 are the same as those of the transport roller 42.

In addition, a washing solution tank (not shown), a pipe (not shown), and a pump (not shown) are connected to the unit 48 dropping a washing solution in the second gum treatment section 8, the unit 48 dropping a washing solution drops the washing solution supplied from the washing solution tank.

Furthermore, the second gum treatment section 8 may further have a transport roller composed of one pair of two rollers on an upstream side of the transport roller 62 in the transport direction.

Thus, Fig. 1 illustrates an example of the second gum treatment section 8 in the present disclosure, but it is needless to say that the second gum treatment section 8 is not limited thereto.

The drying section 10 is provided continuously to the second gum treatment section 8.

The development processing apparatus according to the embodiment of the present disclosure may have or may not have the drying section 10, and for example, the development processing apparatus according to the embodiment of the present disclosure and a drying device may be separated.

The drying section 10 has a support roller 70, transport rollers 74 and 78, each of which is composed of one pair of two rollers, drying units 72 and 76, each of which has one pair of upper and lower ducts, and a lithographic printing plate outlet 80.

The gum-treated lithographic printing plate precursor (not shown) is transported from the second gum treatment section 8, an upper surface and a lower surface of the gum-treated lithographic printing plate precursor (not shown) is dried by the drying units 72 and 76 while the gum-treated lithographic printing plate precursor (not shown) is transported by the support roller 70, and the transport rollers 74 and 78, and a dried lithographic printing plate (not shown) is discharged from the lithographic printing plate outlet 80.

In each of the drying units 72 and 76, dry air generated by a dry air generating unit not shown in the drawing is blown from the ducts of the drying units 72 and 76 toward the gum-treated lithographic printing plate precursor. As a result, the gum solution applied to the upper surface and the lower surface of the gum-treated lithographic printing plate precursor is dried to form a protective film.

The intensity, temperature, and the like of the dry air blown from the drying units 72 and 76 are related to the transport speed, but are not particularly limited, and can be set to desired intensity and temperature.

In addition, a partition board (not shown) may be provided between the second gum treatment section 8 and the drying section 10. The partition board is disposed above the transport path of the gum-treated lithographic printing plate precursor, and as a result, the air in the drying section 10 can be suppressed from entering the second gum treatment section 8.

Thus, Fig. 1 illustrates an example of the drying section 10 in the present disclosure, but it is needless to say that the drying section 10 is not limited thereto.

In addition, the development processing apparatus according to the embodiment of the present disclosure may differ from the above-described configuration in elements which are inessential to the present invention, as defined by the claims..

For example, the development processing apparatus may include, before the development section 4, a preheating unit for performing a heating treatment on the exposed lithographic printing plate precursor.

Next, the lithographic printing plate precursor, developer, washing solution, and gum solution used in the present disclosure will be described.

### <Lithographic printing plate precursor>

As described above, the lithographic printing plate precursor used in the present disclosure is not particularly limited, and a known positive or negative lithographic printing plate precursor can be used.

Among these, from the viewpoint that the effect of halftone dot reproducibility and suppression of unevenness in printing durability of halftone dots is further exhibited, a positive lithographic printing plate precursor is more preferable.

Examples of the lithographic printing plate precursor include various lithographic printing plate precursors in which an image recording layer such as a photosensitive layer and a heat-sensitive layer is provided on a support.

Examples of the image recording layer include thermal positive type image recording layers described in JP1995-285275A (JP-H07-285275A) and JP2003-345014A, thermal negative type image recording layers described in JP1995-020625A (JP-H07-020625A) and JP1999-218903A (JP-H11-218903A), and photopolymer negative type image recording layers described in JP2001-100412A and JP2002-169282A.

The lithographic printing plate precursor used in the present disclosure may further have a known layer such as a protective layer and an undercoat layer.

The support, the image recording layer, the protective layer, the undercoat layer, and the like are not particularly limited, and known ones can be used.

### <Developer>

The details of each component of the developer suitably used in the present disclosure will be described below.

### [pH]

The pH of the developer used in the present disclosure is not particularly limited, but is preferably in a range of 8.5 to 14 and more preferably in a range of 10 to 14. With the above-described range, the effect of halftone dot reproducibility and suppression of unevenness in printing durability of halftone dots is further exhibited.

In the present disclosure, the pH is a value measured at 25°C using a pH meter (model No.: HM-31, manufactured by DKK-TOA Corporation).

An alkaline developer used in the development treatment is an alkaline aqueous solution, and can be appropriately selected from a known alkaline aqueous solution in the related art and used. Suitable examples of the alkaline developer include an alkaline aqueous solution containing an alkali silicate or a non-reducing sugar, and a base, and more suitable examples of the alkaline developer include an alkaline aqueous solution having a pH of 12.5 to 14.0. As the alkaline developer, the description in paragraphs 0270 to 0292 of JP2003-001956A can be referred to.

### [Surfactant]

The developer used in the present disclosure may contain a surfactant such as an anionic surfactant, a non-ionic surfactant, a cationic surfactant, and an amphoteric surfactant.

Among these, from the viewpoint of brush stain property, the developer preferably contains at least one selected from the group consisting of an anionic surfactant and an amphoteric surfactant.

In addition, the developer preferably contains a non-ionic surfactant and more preferably contains a non-ionic surfactant and at least one selected from the group consisting of an anionic surfactant and an amphoteric surfactant.

Preferred examples of the anionic surfactant include a compound represented by Formula (I).

R¹-Y¹-X¹ (I)

In Formula (I), R¹ represents an alkyl group, a cycloalkyl group, an alkenyl group, an aralkyl group, or an aryl group, which may have a substituent.

As the alkyl group, for example, an alkyl group having 1 to 20 carbon atoms is preferable, and preferred specific examples thereof include a methyl group, an ethyl group, a propyl group, an n-butyl group, a sec-butyl group, a hexyl group, a 2-ethylhexyl group, an octyl group, a decyl group, a dodecyl group, a hexadecyl group, and a stearyl group.

The cycloalkyl group may be monocyclic or polycyclic. As the monocyclic cycloalkyl group, a monocyclic cycloalkyl group having 3 to 8 carbon atoms is preferable, and a cyclopropyl group, a cyclopentyl group, a cyclohexyl group, or a cyclooctyl group is more preferable. Preferred examples of the polycyclic cycloalkyl group include an adamantyl group, a norbornyl group, an isobornyl group, a camphanyl group, a dicyclopentyl group, an α-pinel group, and a tricyclodecanyl group.

As the alkenyl group, for example, an alkenyl group having 2 to 20 carbon atoms is preferable, and preferred specific examples thereof include a vinyl group, an allyl group, a butenyl group, and a cyclohexenyl group.

As the aralkyl group, for example, an aralkyl group having 7 to 12 carbon atoms is preferable, and preferred specific examples thereof include a benzyl group, a phenethyl group, and a naphthylmethyl group.

As the aryl group, for example, an aryl group having 6 to 15 carbon atoms is preferable, and preferred specific examples thereof include a phenyl group, a tolyl group, a dimethylphenyl group, a 2,4,6-trimethylphenyl group, a naphthyl group, an anthryl group, and a 9,10-dimethoxyanthryl group.

As the substituent, a monovalent nonmetallic atomic group excluding a hydrogen atom is used, and preferred examples thereof include a halogen atom (F, Cl, Br, or I), a hydroxy group, an alkoxy group, an aryloxy group, an acyl group, an amide group, an ester group, an acyloxy group, a carboxy group, a carboxylic acid anion group, and a sulfonic acid anion group.

As specific examples of the alkoxy group in the substituent, a methoxy group, an ethoxy group, a propyloxy group, an isopropyloxy group, a butyloxy group, a pentyloxy group, a hexyloxy group, a dodecyloxy group, a stearyloxy group, a methoxyethoxy group, a poly(ethyleneoxy) group, and a poly(propyleneoxy) group, respectively having 1 to 40 carbon atoms, are preferable; and these groups respectively having 1 to 20 carbon atoms are more preferable. Examples of the aryloxy group include a phenoxy group, a tolyloxy group, a xylyloxy group, a mesityloxy group, a cumenyloxy group, a methoxyphenyloxy group, an ethoxyphenyloxy group, a chlorophenyloxy group, a bromophenyloxy group, and a naphthyloxy group, respectively having 6 to 18 carbon atoms. Examples of the acyl group include an acetyl group, a propanoyl group, a butanoyl group, a benzoyl group, and a naphthoyl group, respectively having 2 to 24 carbon atoms. Examples of the amide group include an acetamide group, a propionic acid amide group, a dodecanoic acid amide group, a palmitic acid amide group, a stearic acid amide group, a benzoic acid amide group, and a naphthoic acid amide group, respectively having 2 to 24 carbon atoms. Examples of the acyloxy group include an acetoxy group, a propanoyloxy group, a benzoyloxy group, and a naphthoyloxy group, respectively having 2 to 20 carbon atoms. Examples of the ester group include a methyl ester group, an ethyl ester group, a propyl ester group, a hexyl ester group, an octyl ester group, a dodecyl ester group, and a stearyl ester group, respectively having 1 to 24 carbon atoms. The substituent may be formed by consisting of a combination of two or more substituents described above.

X¹ represents a sulfonate group, a sulfate monoester group, a carboxylate group, or a phosphate group.

Y¹ represents a single bond, -CₙH₂ₙ-, -Cₙ₋ₘH₂₍ₙ₋ₘ₎OCₘH₂ₘ-, -O-(CH₂CH₂O)ₙ-, -O-(CH₂CH(CH₃)O)ₙ-, -O-(CH(CH₃)CH₂O)ₙ-, -O-(CH₂CH₂CH₂O)ₙ-, -CO-NH-, or a divalent linking group formed by consisting of a combination of two or more of these, in which the expressions of "n≥1" and "n≥m≥0" is satisfied.

Among examples of the compound represented by Formula (I), from the viewpoint of scratch and stain resistance, a compound represented by Formula (I-A) or Formula (I-B) is preferable.

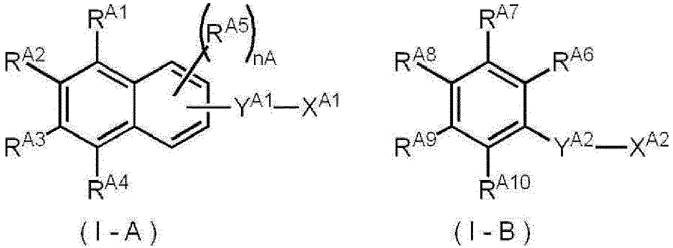

In Formulae (I-A) and (I-B), R^{A1} to R^{A10} each independently represent a hydrogen atom or an alkyl group, nA represents an integer of 1 to 3, X^{A1} and X^{A2} each independently represent a sulfonate group, a sulfate monoester group, a carboxylate group, or a phosphate group, and Y^{A1} and Y^{A2} each independently represent a single bond, -CₙH₂ₙ-, -Cₙ₋ₘH₂₍ₙ₋ₘ₎OCₘH₂ₘ-, -O-(CH₂CH₂O)ₙ-, -O-(CH₂CH(CH₃)O)ₙ-, -O-(CH(CH₃)CH₂O)ₙ-, -O-(CH₂CH₂CH₂O)ₙ-, -CO-NH-, or a divalent linking group formed by combining two or more of these, in which the expressions of "n≥1" and "n≥m≥0" is satisfied. The sum total number of carbon atoms in R^{A1} to R^{A5} or R^{A6} to R^{A10}, and Y^{A1} or Y^{A2} is 3 or greater.

The total number of carbon atoms in R^{A1} to R^{A5} and Y^{A1}, or R^{A6} to R^{A10} and Y^{A2} in the compound represented by Formula (I-A) or Formula (I-B) is preferably 25 or less and more preferably in a range of 4 to 20. The structure of the above-described alkyl group may be linear or branched.

It is preferable that X^{A1} and X^{A2} in the compound represented by Formula (I-A) or Formula (I-B) represent a sulfonate group or a carboxylate group. In addition, the salt structure in X^{A1} and X^{A2} is preferable, from the viewpoint that the solubility of the alkali metal salt in a water-based solvent is particularly excellent. Among the salt structures, a sodium salt or a potassium salt is particularly preferable.

As the compound represented by Formula (I-A) or Formula (I-B), the description in paragraphs 0019 to 0037 ofJP2007-206348Acan be referred to.

Furthermore, as the anionic surfactant, the compounds described in paragraphs 0023 to 0028 of JP2006-065321A can be suitably used.

The amphoteric surfactant used for the developer according to the present disclosure is not particularly limited, and examples thereof include an amine oxide-based surfactant such as alkyl dimethylamine oxide; a betaine-based surfactant such as alkyl betaine, fatty acid amide propyl betaine, or alkyl imidazole; and an amino acid-based surfactant such as sodium alkylamino fatty acid.

In particular, alkyl dimethylamine oxide which may have a substituent, alkyl carboxy betaine which may have a substituent, or alkyl sulfobetaine which may have a substituent is preferably used. Specific examples thereof include compounds represented by Formula (2) in paragraph 0256 of JP2008-203359A, compounds represented by Formulae (I), Formula (II), and Formula (VI) in paragraph 0028 of JP2008-276166A, and compounds described in paragraphs 0022 to 0029 of JP2009-047927A.

As an amphoteric ion-based surfactant used for the developer, a compound represented by formula (1) or a compound represented by Formula (2) is preferable.

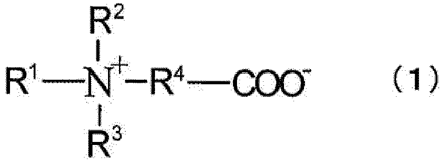

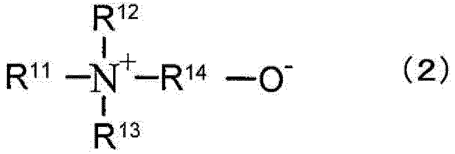

In Formulae (1) and (2), R¹ and R¹¹ each independently represent an alkyl group having 8 to 20 carbon atoms or an alkyl group having a linking group, which has 8 to 20 carbon atoms in total.

R², R³, R¹², and R¹³ each independently represent a hydrogen atom, an alkyl group, or a group containing an ethylene oxide group.

R⁴ and R¹⁴ each independently represent a single bond or an alkylene group.

In addition, two groups among R¹, R², R³, and R⁴ may be bonded to each other to form a ring structure, and two groups among R¹¹, R¹², R¹³, and R¹⁴ may be bonded to each other to form a ring structure.

In the compound represented by Formula (1) or the compound represented by Formula (2), the hydrophobic portion is bigger as the total number of carbon atoms increases, and the solubility in a water-based developer is decreased. In this case, the solubility is improved by mixing an organic solvent such as alcohol that assists dissolution with water as a dissolution assistant, but the surfactant cannot be dissolved within a proper mixing range in a case where the total number of carbon atoms is extremely large. Accordingly, the sum total number of carbon atoms of R¹ to R⁴ or R¹¹ to R¹⁴ is preferably in a range of 10 to 40 and more preferably in a range of 12 to 30.

The alkyl group having a linking group represented by R¹ or R¹¹ has a structure in which a linking group is present between alkyl groups. In other words, in a case where one linking group is present, the structure can be represented by "-alkylene group-linking group-alkyl group". Examples of the linking group include an ester bond, a carbonyl bond, and an amide bond. The structure may have two or more linking groups, but it is preferable that the structure has one linking group, and an amide bond is particularly preferable. The total number of carbon atoms of the alkylene group bonded to the linking group is preferably in a range of 1 to 5. The alkylene group may be linear or branched, but a linear alkylene group is preferable. The number of carbon atoms of the alkyl group bonded to the linking group is preferably in a range of 3 to 19, and the alkyl group may be linear or branched, but a linear alkyl is preferable.

In a case where R² or R¹² represents an alkyl group, the number of carbon atoms thereof is preferably in a range of 1 to 5 and particularly preferably in a range of 1 to 3. The alkyl group may be linear or branched, but a linear alkyl group is preferable.

In a case where R³ or R¹³ represents an alkyl group, the number of carbon atoms thereof is preferably in a range of 1 to 5 and particularly preferably in a range of 1 to 3. The alkyl group may be linear or branched, but a linear alkyl group is preferable.

Examples of the group containing an ethylene oxide represented by R³ or R¹³ include a group represented by -R^{a}(CH₂CH₂O)ₙR^{b}. Here, R^{a} represents a single bond, an oxygen atom, or a divalent organic group (preferably having 10 or less carbon atoms), R^{b} represents a hydrogen atom or an organic group (preferably having 10 or less carbon atoms), and n represents an integer of 1 to 10.

In a case where R⁴ and R¹⁴ represents an alkylene group, the number of carbon atoms thereof is preferably in a range of 1 to 5 and particularly preferably in a range of 1 to 3. The alkylene group may be linear or branched, but a linear alkylene group is preferable.

The compound represented by Formula (1) or the compound represented by Formula (2) preferably has an amide bond and more preferably has an amide bond as a linking group of R¹or R¹¹.

Representative examples of the compound represented by Formula (1) or the compound represented by Formula (2) are as follows, but the present disclosure is not limited thereto.

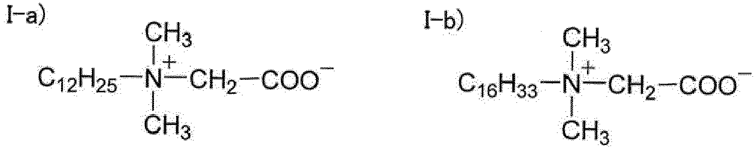

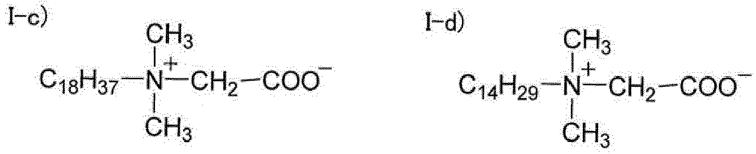

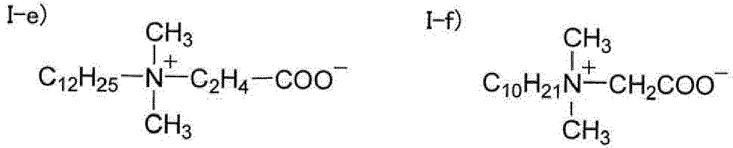

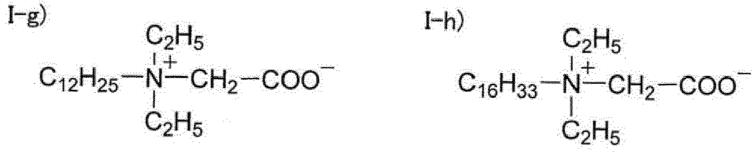

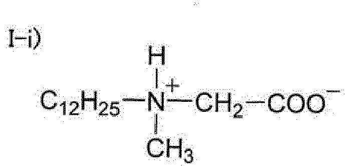

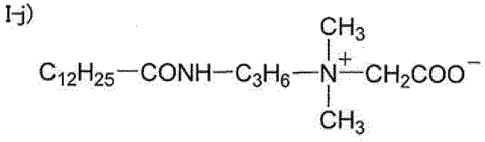

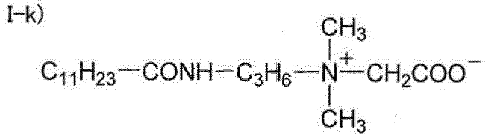

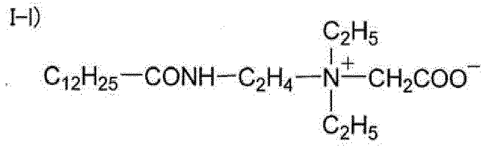

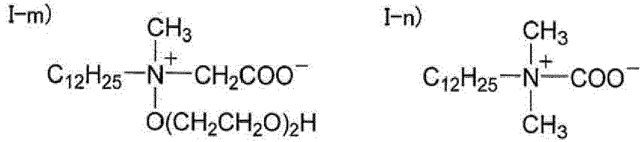

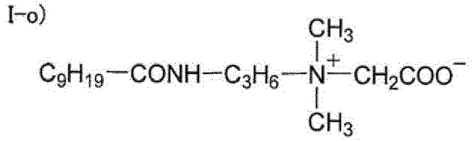

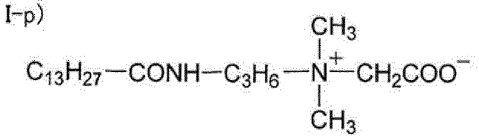

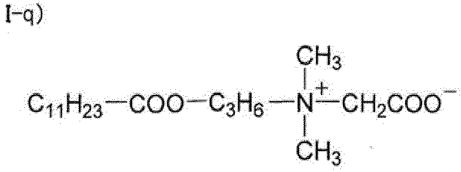

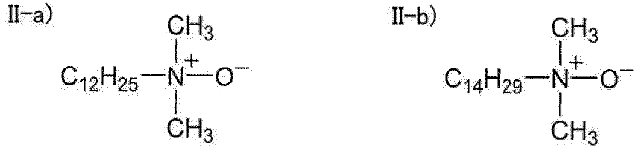

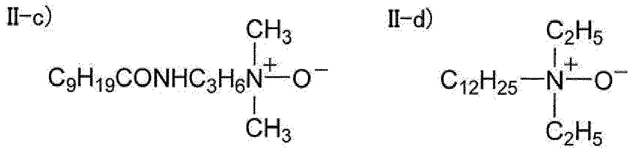

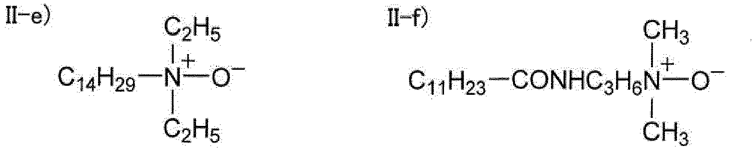

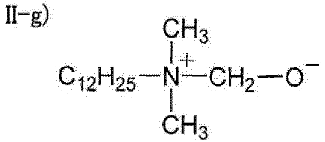

The compound represented by Formula (1) or Formula (2) can be synthesized according to a known method. In addition, commercially available products may be used. Examples of the commercially available products of the compound represented by Formula (1) include SOFRAZOLINE LPB, SOFTAZOLINE LPB-R, and VISTA MAP (manufactured by Kawaken Fine Chemicals Co., Ltd.), and TAKESAAF C-157L (manufactured by TAKEMOTO OIL & FAT Co., Ltd.). Examples of the commercially available products of the compound represented by Formula (2) include SOFTAZOLINE LAO (manufactured by Kawaken Fine Chemicals Co., Ltd.) and AMOGEN AOL (manufactured by DKS Co., Ltd.).

The amphoteric ion-based surfactant may be used alone or in combination of two or more kinds thereof in a developer.

Examples of non-ionic surfactant include polyoxyethylene alkyl ethers, polyoxyethylene alkyl phenyl ethers, polyoxyethylene polystyryl phenyl ether, glycerin fatty acid partial esters, sorbitan fatty acid partial esters, pentaerythritol fatty acid partial esters, propylene glycol monofatty acid ester, sucrose fatty acid partial esters, polyoxyethylene sorbitan fatty acid partial esters, polyoxyethylene sorbitol fatty acid partial esters, polyethylene glycol fatty acid esters, polyglycerin fatty acid partial esters, polyoxyethylene glycerin fatty acid partial esters, polyoxyethylene diglycerins, fatty acid diethanolamides, N,N-bis-2-hydroxyalkylamines, polyoxyethylene alkylamine, triethanolamine fatty acid ester, trialkylamine oxide, polyoxyethylene alkyl phenyl ethers, and polyoxyethylene-polyoxypropylene block copolymers.

In addition, acetylene glycol-based and acetylene alcohol-based oxyethylene adducts, and fluorine-based surfactants can also be used. These surfactants can be used in combination of two or more kinds thereof.

Particularly preferred examples of the non-ionic surfactant include a non-ionic aromatic ether-based surfactant represented by Formula (N1).

X^{N}-Y^{N}-O-(A¹)_{nB}-(A²)_{mB}-H (N1)

In the formula, X^{N} represents an aromatic group which may have a substituent, Y^{N} represents a single bond or an alkylene group having 1 to 10 carbon atoms, A¹ and A² are different groups and represent any of -CH₂CH₂O- or -CH₂CH(CH₃)O-, and nB and mB each independently represent an integer of 0 to 100, provided that both of nB and mB is not 0 at the same time, and both of nB and mB is not 1 in a case where any one of nB or mB is 0.

In the formula, examples of the aromatic group of X^{N} include a phenyl group, a naphthyl group, and an anthranyl group. These aromatic groups may have a substituent. Examples of the substituent include an organic group having 1 to 100 carbon atoms. In the formula, the compound may be a random or block copolymer in a case where both A¹ and A² are present.

Specific examples of the organic group having 1 to 100 carbon atoms include aliphatic hydrocarbon groups or aromatic hydrocarbon groups, which may be saturated or unsaturated and may be linear or branched, such as an alkyl group, an alkenyl group, an alkynyl group, an aryl group, an aralkyl group, an alkoxy group, an aryloxy group, a N-alkylamino group, a N,N-dialkylamino group, a N-arylamino group, a N,N-diarylamino group, a N-alkyl-N-arylamino group, an acyloxy group, a carbamoyloxy group, a N-alkylcarbamoyloxy group, a N-arylcarbamoyloxy group, a N,N-dialkylcarbamoyloxy group, a N,N-diarylcarbamoyloxy group, a N-alkyl-N-arylcarbamoyloxy group, an acylamino group, a N-alkylacylamino group, a N-arylacylamino group, an acyl group, an alkoxycarbonylamino group, an alkoxycarbonyl group, an aryloxycarbonyl group, a carbamoyl group, a N-alkylcarbamoyl group, a N,N-dialkylcarbamoyl group, a N-arylcarbamoyl group, a N,N-diarylcarbamoyl group, a N-alkyl-N-arylcarbamoyl group, a polyoxyalkylene chain, and the above-described organic group to which a polyoxyalkylene chain is bonded. The alkyl group may be linear or branched.

In addition, as the non-ionic surfactant, compounds described in paragraphs 0030 to 0040 of JP2006-065321 A can also be suitably used.

The cationic surfactant is not particularly limited, and known surfactants of the related art can be used. Examples thereof include alkylamine salts, quaternary ammonium salts, alkylimidazolinium salts, polyoxyethylene alkylamine salts, and polyethylene polyamine derivatives.

The surfactant may be used alone or in combination of two or more kinds thereof.

The content of the surfactant is preferably in a range of 1% by mass to 25% by mass, more preferably in a range of 2% by mass to 20% by mass, still more preferably in a range of 3% by mass to 15% by mass, and particularly preferably in a range of 5% by mass to 10% by mass with respect to the total mass of the developer. In a case where the content thereof is in the above-described range, scratch and stain resistance is more excellent, the dispersibility of the development scum is excellent, and the inking property of a lithographic printing plate to be obtained is excellent.

### [Other additives]

The developer used in the present disclosure may contain a wetting agent, a preservative, a chelate compound, an anti-foaming agent, an organic acid, an organic solvent, an inorganic acid, and an inorganic salt in addition to those described above.

Suitable examples of the wetting agent include ethylene glycol, propylene glycol, triethylene glycol, butylene glycol, hexylene glycol, diethylene glycol, dipropylene glycol, glycerin, trimethylolpropane, and diglycerin. The wetting agent may be used alone or in combination of two or more kinds thereof. The content of the wetting agent is preferably in a range of 0.1% by mass to 5% by mass with respect to the total mass of the developer.

As the preservative, phenol or a derivative thereof, formalin, an imidazole derivative, sodium dehydroacetate, a 4-isothiazolin-3-one derivative, benzoisothiazolin-3-one, 2-methyl-4-isothiazolin-3-one, a benzotriazole derivative, an amidizing anidine derivative, quaternary ammonium salts, derivatives of pyridine, quinoline, guanidine, and the like, diazine, a triazole derivative, oxazole, an oxazine derivative, nitrobromoalcohol such as 2-bromo-2-nitropropane-1,3-diol, 1,1-dibromo -1-nitro-2-ethanol, and 1,1-dibromo-1-nitro-2-propanol, and the like can be preferably used.

The addition amount of the preservative is an amount of stably exhibiting the efficacy for bacteria, molds, yeasts, or the like, and is preferably in a range of 0.01% by mass to 4% by mass with respect to the total mass of the developer, even though the amount thereof varies depending on the type of bacteria, molds, and the yeasts. In addition, two or more preservatives are preferably used in combination so that there is efficacy for a variety of molds and bacteria.

Examples of the chelate compound include ethylenediaminetetraacetic acid, a potassium salt thereof, and a sodium salt thereof; diethylenetriaminepentaacetic acid, a potassium salt thereof, and a sodium salt thereof; triethylenetetraminehexaacetic acid, a potassium salt thereof, a sodium salt thereof; hydroxyethylethylenediaminetriacetic acid, a potassium salt thereof, and a sodium salt thereof; nitrilotriacetic acid and a sodium salt thereof; 1-hydroxyethane-1,1-diphosphonic acid, a potassium salt thereof, and a sodium salt thereof; and organic phosphonic acids such as amino tri(methylenephosphonic acid), a potassium salt thereof, and sodium salt thereof. Instead of the sodium salt and the potassium salt of the chelating agent, a salt of an organic amine is also effective.

These chelating agents are preferably a chelating agent that is stably present in the developer and does not impair printability. The content of the chelating agent is preferably in a range of 0.001% by mass to 1.0% by mass with respect to the total mass of the developer.

As the anti-foaming agent, it is possible to use a typical silicone-based self-emulsification type, emulsification type, or non-ionic compound having a hydrophilic-lipophilic balance (HLB) of 5 or lower or the like. A silicone anti-foaming agent is preferable.

In the present disclosure, a silicone-based surfactant is regarded as the anti-foaming agent.

The content of the anti-foaming agent is suitably in a range of 0.001% by mass to 1.0% by mass with respect to the total mass of the developer.

Examples of the organic acid include citric acid, acetic acid, oxalic acid, malonic acid, salicylic acid, caprylic acid, tartaric acid, malic acid, lactic acid, levulinic acid, p-toluenesulfonic acid, xylenesulfonic acid, phytic acid, and organic phosphonic acid. The organic acid can be used in the form of an alkali metal salt or ammonium salt thereof. The content of the organic acid is preferably in a range of 0.01% by mass to 0.5% by mass with respect to the total mass of the developer.

Examples of a containable organic solvent include aliphatic hydrocarbons (hexane, heptane, "ISOPAR E, H, G" (manufactured by Exxon Mobil Corporation), gasoline, kerosene, and the like), aromatic hydrocarbons (toluene, xylene, and the like), halogenated hydrocarbon (methylene dichloride, ethylene dichloride, trichlene, monochlorobenzene, and the like), and polar solvents.

Examples of the polar solvent include alcohols (such as methanol, ethanol, propanol, isopropanol, benzyl alcohol, ethylene glycol monomethyl ether, 2-ethoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methyl phenyl carbinol, n-amyl alcohol, and methyl amyl alcohol), ketones (such as acetone, methyl ethyl ketone, ethyl butyl ketone, methyl isobutyl ketone, and cyclohexanone), esters (such as ethyl acetate, propyl acetate, butyl acetate, amyl acetate, benzyl acetate, methyl lactate, butyl lactate, ethylene glycol monobutyl acetate, propylene glycol monomethyl ether acetate, diethylene glycol acetate, diethyl phthalate, and butyl levulinate), and others (such as triethyl phosphate, tricresyl phosphate, N-phenylethanolamine, and N-phenyldiethanolamine).

In a case where the organic solvent is insoluble in water, the organic solvent can be used by being solubilized in water using a surfactant or the like. In a case where the developer contains an organic solvent, from the viewpoint of safety and inflammability, the concentration of the solvent in the developer is preferably less than 40% by mass.

Examples of the inorganic acid and inorganic salt include phosphoric acid, methacrylic acid, primary ammonium phosphate, secondary ammonium phosphate, primary sodium phosphate, secondary sodium phosphate, primary potassium phosphate, secondary potassium phosphate, sodium tripolyphosphate, potassium pyrophosphate, sodium hexametaphosphate, magnesium nitrate, sodium nitrate, potassium nitrate, ammonium nitrate, sodium sulfate, potassium sulfate, ammonium sulfate, sodium sulfite, ammonium sulfite, sodium hydrogensulfate, and nickel sulfate. The content of the inorganic salt is preferably in a range of 0.01% by mass to 0.5% by mass with respect to the total mass of the developer.

The developer used in the present disclosure is obtained by dissolving or dispersing each of the above-described components in water as necessary. The concentration of solid contents of the developer is preferably in a range of 2% by mass to 25% by mass. In addition, the developer can be used by preparing a concentrated solution and diluting the concentrate with water before use.

In addition, it is preferable that the developer used in the present disclosure is an aqueous developer.

In addition, from the viewpoint of the dispersibility of the development scum, the developer used in the present disclosure preferably contains an alcohol compound.

Examples of the alcohol compound include methanol, ethanol, propanol, isopropanol, and benzyl alcohol. Among these, benzyl alcohol is preferable.

From the viewpoint of the dispersibility of the development scum, the content of the alcohol compound is preferably 0.01% by mass to 5% by mass, more preferably 0.1% by mass to 2% by mass, and particularly preferably 0.2% by mass to 1% by mass with respect to the total mass of the developer.

### <Washing solution>

The details of each component of the washing solution suitably used in the present disclosure will be described below.

Preferably, the washing solution may be only water, such as tap water, well water, pure water, and ion exchange water, or may be an aqueous solution including the following components, as long as the purpose of diluting or removing the gum solution remaining on the roller with a washing water is not impaired.

The content of water in the washing solution is not particularly limited, but is preferably 50% by mass or more, more preferably 80% by mass or more, and particularly preferably 90% by mass or more.

The washing solution is preferably neutral (preferably pH 5 to 9 and more preferably pH 6 to 8), and preferably includes a pH adjuster to maintain neutrality.

As the pH adjuster, a buffer compound used in a known buffer solution can be used.

In addition, the washing solution may contain a surfactant, a lipophilic substance, a preservative, a fungicide, an anti-foaming agent, and the like.

Among these, from the viewpoint of storage stability, it is preferable to contain at least a preservative, and it is more preferable that the washing solution is an aqueous solution containing a preservative.

As the preservative, a known substance used in the fields of fiber, wood working, food, medicine, cosmetics, agrochemicals, and the like can be used.

For example, a known preservative such as a quaternary ammonium salt, a monohydric phenol derivative, a dihydric phenol derivative, a polyhydric phenol derivative, an imidazole derivative, a pyrazolopyrimidine derivative, a monohydric naphthol, carbonates, a sulfone derivative, an organotin compound, a cyclopentane derivative, a phenyl derivative, a phenol ether derivative, a phenol ester derivative, a hydroxylamine derivative, a nitrile derivative, naphthalenes, a pyrrole derivative, a quinoline derivative, a benzothiazole derivative, a secondary amine, a 1,3,5-triazine derivative, a thiadiazole derivative, an anilide derivative, a pyrrole derivative, a halogen derivative, a dihydric alcohol derivative, dithiols, a cyanic acid derivative, a thiocarbamic acid derivative, a diamine derivative, an isothiazole derivative, a monohydric alcohol, a saturated aldehyde, an unsaturated monocarboxylic acid, a saturated ether, an unsaturated ether,

lactones, an amino acid derivative, hydantoin, a cyanuric acid derivative, a guanidine derivative, a pyridine derivative, a saturated monocarboxylic acid, a benzenecarboxylic acid derivative, a hydroxycarboxylic acid derivative, biphenyl, a hydroxamic acid derivative, an aromatic alcohol, a halogenophenol derivative, a benzenecarboxylic acid derivative, a mercaptocarboxylic acid derivative, a quaternary ammonium salt derivative, a triphenylmethane derivative, hinokitiol, a furan derivative, a benzofuran derivative, an acridine derivative, an isoquinoline derivative, an arsine derivative, a thiocarbamic acid derivative, a phosphoric acid ester, a halogenobenzene derivative, a quinone derivative, a benzenesulfonic acid derivative, a monoamine derivative, organic phosphate, a piperazine derivative, a phenazine derivative, a pyrimidine derivative, a thiophanate derivative, an imidazoline derivative, an isoxazole derivative, and an ammonium salt derivative can be used.

Particularly preferred examples of the preservative include a pyridinethiol-1-oxide salt, salicylic acid and a salt thereof, 1,3,5-trishydroxyethylhexahydro-S-triazine, 1,3,5-trishydroxymethylhexahydro-S-triazine, 1,2-benzisothiazolin-3 -one, 5-chloro-2-methyl-4-isothiazolin-3-one, and 2-bromo-2-nitro-1,3-propanediol.

The addition amount of the preservative is an amount of stably exhibiting the efficacy for bacteria, molds, yeasts, or the like, and is preferably in a range of 50 ppm to 5,000 ppm and more preferably in a range of 100 ppm to 3,000 ppm, even though the amount thereof varies depending on the type of bacteria, molds, and the yeasts.

In addition, two or more preservatives are preferably used in combination so that there is efficacy for a variety of molds and bacteria.

In addition, as a commercially available product of the preservative, BK-3 manufactured by FUJIFILM Corporation is suitably used.

Examples of the surfactant include an anionic surfactant, a cationic surfactant, an amphoteric surfactant, and a non-ionic surfactant.

Examples of the anionic surfactant include fatty acid salts, abietic acid salts, hydroxyalkanesulfonic acid salts, alkanesulfonic acid salts, α-olefinsulfonic acid salts, dialkylsulfosuccinic acid salts, alkyldiphenyletherdisulfonic acid salts, linear alkylbenzenesulfonic acid salts, branched alkylbenzene sulfonates, alkylnaphthalene sulfonates, alkylphenoxy polyoxyethylene propyl sulfonates, polyoxyethylene alkyl sulfophenyl ether salts, N-methyl-N-oleyl taurine sodium salts, N-alkylsulfosuccinic acid monoamide disodium salts, petroleum sulfonates, sulfated castor oil, sulfated beef tallow oil, sulfate salts of fatty acid alkyl esters, alkyl sulfate ester salts, polyoxyethylene alkyl ether sulfate ester salts, fatty acid monoglyceride sulfate ester salts, polyoxyethylene alkylphenyl ether sulfate ester salts, polyoxyethylene styrylphenyl ether sulfate ester salts, alkyl phosphate ester salts, polyoxyethylene alkyl ether phosphate ester salts, polyoxyethylene alkylphenyl ether phosphate ester salts, partially saponified styrene-maleic anhydride copolymers, partially saponified olefin-maleic anhydride copolymers, and naphthalene sulfonate formalin condensates.

Among these, at least one compound selected from the group consisting of dialkylsulfosuccinic acid salts, alkyl sulfate ester salts, alkylnaphthalene sulfonates, α-olefinsulfonic acid salts, and alkyldiphenyletherdisulfonic acid salts is particularly preferably used.

As the cationic surfactant, alkylamine salts, quaternary ammonium salts, and the like are used.

As the amphoteric surfactant, alkyl carboxy betaines, alkyl imidazolines, alkyl amino carboxylic acids, and the like are used.

Examples of the non-ionic surfactant include polyoxyethylene alkyl ethers, polyoxyethylene alkyl phenyl ethers, polyoxyethylene polystyryl phenyl ether, polyoxyethylene polyoxypropylene alkyl ether, glycerin fatty acid partial esters, sorbitan fatty acid partial esters, pentaerythritol fatty acid partial esters, propylene glycol monofatty acid ester, sucrose fatty acid partial esters, polyoxyethylene sorbitan fatty acid partial esters, polyoxyethylene sorbitol fatty acid partial esters, polyethylene glycol fatty acid esters, polyglycerin fatty acid partial esters, polyoxyethylenated castor oils, polyoxyethylene glycerin fatty acid partial esters, fatty acid diethanolamides, N,N-bis-2-hydroxyalkylamines, polyoxyethylene alkylamine, triethanolamine fatty acid ester, trialkylamine oxide, polyoxyethylene or polyoxypropylene adducts of polypropylene glycol, trimethylolpropane, glycerin, or sorbitol, which has a molecular weight of 200 to 5,000, and an acetylene glycol-based surfactant.

In addition, fluorine-based or silicone-based non-ionic surfactants can be used as well.

The surfactant may be contained alone or in combination of two or more thereof.

The content of the surfactant is not particularly limited, but is preferably in a range of 0.01% by mass to 20% by mass and more preferably in a range of 0.05% by mass to 10% by mass with respect to the total mass of the washing solution.

In addition, the washing solution may contain an anti-foaming agent.

As the anti-foaming agent, a known anti-foaming agent can be used, and a silicone anti-foaming agent is preferable. In addition, as the silicone anti-foaming agent, both an emulsion dispersion type and a solubilizing type can be used.

The anti-foaming agent may be contained alone or in combination of two or more thereof.

The content of the anti-foaming agent is not particularly limited, but is preferably in a range of 0.001% by mass to 1.0% by mass with respect to the total mass of the washing solution.

In a case where the washing water contains an alkaline earth metal such as calcium and magnesium, or a metal ion, in order to prevent the generation of precipitates in the gum treatment section 6, for example, neutral salts such as NaCl, KCI, and KBr described in JP1983-075152A (JP-S58-075152A) and chelating agents such as ethylenediaminetetraacetic acid (EDTA) and nitrilotriacetic acid (NTA) described in JP1984-190952A (JP-S59-190952A) may be included.

In addition, as long as the purpose of diluting or removing the gum solution remaining on the roller with a washing water is not impaired, the washing water may include a gum component, or may be a diluting solution of the gum solution used in the gum treatment section. The concentration of the gum component in the washing water is preferably 25% by mass or less, more preferably 20% by mass or less, still more preferably 10% by mass or less, and particularly preferably 5% by mass or less with respect to the concentration of the gum component in the gum solution used in the gum treatment section.

### <Gum solution>

The details of each component of the gum solution suitably used in the present disclosure will be described below.

The gum solution preferably contains water.

The content of water in the gum solution is not particularly limited, but is preferably 30% by mass or more, more preferably 50% by mass or more, and particularly preferably 70% by mass or more.

The gum solution preferably contains a water-soluble polymer compound.

Examples of the water-soluble polymer compound include gum arabic, a fiber derivative (such as carboxymethyl cellulose, carboxyethyl cellulose, methyl cellulose, hydroxypropyl cellulose, and methylpropyl cellulose) and a modified product thereof, a polyvinyl alcohol and a derivative thereof, polyvinylpyrrolidone, polyacrylamide, a vinyl methyl ether/maleic anhydride copolymer, a vinyl acetate/maleic anhydride copolymer, a styrene/maleic anhydride copolymer, a starch derivative (such as dextrin, maltodextrin, enzymatically degraded dextrin, hydroxypropylated starch, hydroxypropylated starch enzymatically degraded dextrin, carboxydimethylated starch, phosphorylated starch, and cyclodextrin), and pullulan and a pullulan derivative.

In addition, examples of other starch derivatives which can be used as the water-soluble polymer compound include roasted starch such as British gum; enzymatically-modified dextrin such as enzyme dextrin and Schardinger dextrin; oxidized starch such as solubilized starch; pregelatinized starch such as modified pregelatinized starch and unmodified pregelatinized starch; esterified starch such as starch phosphate, fatty starch, starch sulfate, starch nitrate, starch xanthate, and starch carbamate; etherified starch such as a carboxyalkyl starch, hydroxyalkyl starch, sulfoalkyl starch, cyanoethyl starch, allyl starch, benzyl starch, carbamylethyl starch, and a dialkylamino starch; crosslinked starch such as methylol-crosslinked starch, hydroxyalkyl-crosslinked starch, phosphoric acid-crosslinked starch, and dicarboxylic acid-crosslinked starch; and starch graft polymers such as a starch-polyacrylamide copolymer, a starch-polyacrylic acid copolymer, a starch-polyvinyl acetate copolymer, a starch-polyacrylonitrile copolymer, a cationic starch-polyacrylic acid ester copolymer, a cationic starch-vinyl polymer copolymer, a starch-polystyrene-maleic acid copolymer, a starch-polyethylene oxide copolymer, and a starch-polypropylene copolymer.

As a natural polymer compound which can be used as the water-soluble polymer compound, water-soluble soybean polysaccharides; starches such as starch, gelatin, hemicellulose extracted from soybean, sweet potato starch, potato starch, tapioca starch, wheat starch, and corn starch; a polymer compound obtained from seaweed such as carrageenan, laminaran, seaweed mannan, funori, Irish moss, agar, and sodium alginate; plant mucilage such as tororoaoi, mannan, quince seed, pectin, tragacanth gum, karaya gum, xanthine gum, guar bean gum, locust bean gum, carob gum, and benzoin gum; bacteria mucilage such as homopolysaccharide, for example, dextran, glucan, levan, and the like, and heteropolysaccharide, for example, succinoglucan, xanthan gum, and the like; or protein such as glue, gelatin, casein, and collagen is preferable.

Among these, as the water-soluble polymer compound, gum arabic, a starch derivative such as dextrin and hydroxypropylated starch, carboxymethyl cellulose, soybean polysaccharides, and the like can be preferably used.

The content of the water-soluble polymer compound is preferably in a range of 0.1% by mass to 25.0% by mass and more preferably in a range of 0.3% by mass to 20.0% by mass with respect to the total mass of the gum solution.

The pH of the gum solution is preferably acidic, and more preferably pH 2 to 6. In order to set the pH of the gum solution to the above-described range, it is preferable to add a pH adjuster such as a mineral acid, an organic acid, and a salt thereof in the gum solution to adjust the pH.

Examples of the pH adjuster include, as a mineral acid, nitric acid, sulfuric acid, phosphoric acid, metaphosphoric acid, and polyphosphoric acid. Examples of the organic acid include acetic acid, oxalic acid, citric acid, malic acid, malonic acid, tartaric acid, p-toluenesulfonic acid, lactic acid, repulinic acid, phytic acid, and organic phosphonic acid. Examples of the salt which can be preferably used include disodium hydrogen phosphate, dipotassium hydrogen phosphate, diammonium hydrogen phosphate, sodium dihydrogen phosphate, potassium dihydrogen phosphate, ammonium dihydrogen phosphate, potassium pyrophosphate, sodium hexametaphosphate, sodium tripolyphosphate, sodium nitrate, potassium nitrate, ammonium nitrate, and sulfuric acid sodium.

The pH adjuster may be used alone or in combination of two or more kinds thereof.

The content of the pH adjuster is preferably in a range of 0.01% by mass to 3.0% by mass with respect to the total mass of the gum solution.

An alkaline agent may be added to the gum solution to adjust the pH of the gum solution.

As the alkaline agent used in the gum solution, a known alkaline agent in the related art can be appropriately selected and used. Examples of the alkaline agent include compounds described in paragraphs 0083 and 0084 of JP1999-216962A (JP-H11-216962A). These may be used alone or in combination of two or more thereof.

The gum solution preferably further contains a surfactant.

Examples of the surfactant include an anionic surfactant and a non-ionic surfactant.

Examples of the anionic surfactant include fatty acid salts, abietic acid salts, hydroxyalkanesulfonic acid salts, alkanesulfonic acid salts, dialkylsulfosuccinic acid salts, linear alkylbenzenesulfonic acid salts, branched alkylbenzene sulfonates, alkylnaphthalene sulfonates, alkylphenoxy polyoxyethylene propyl sulfonates, polyoxyethylene alkyl sulfophenyl ether salts, N-methyl-N-oleyl taurine sodium salts, N-alkylsulfosuccinic acid monoamide disodium salts, petroleum sulfonates, sulfated castor oil, sulfated beef tallow oil, sulfate salts of fatty acid alkyl esters, alkyl sulfate ester salts, polyoxyethylene alkyl ether sulfate ester salts, fatty acid monoglyceride sulfate ester salts, polyoxyethylene alkylphenyl ether sulfate ester salts, polyoxyethylene styrylphenyl ether sulfate ester salts, alkyl phosphate ester salts, polyoxyethylene alkyl ether phosphate ester salts, polyoxyethylene alkylphenyl ether phosphate ester salts, partially saponified styrene-maleic anhydride copolymers, partially saponified olefin-maleic anhydride copolymers, and naphthalene sulfonate formalin condensates.

Among these, dialkylsulfosuccinic acid salts, alkyl sulfate ester salts, or alkylnaphthalene sulfonates are particularly preferably used.

Examples of the non-ionic surfactant include polyoxyethylene alkyl ethers, polyoxyethylene-polyoxypropylene block copolymers, polyoxyethylene alkyl phenyl ethers, polyoxyethylene polystyryl phenyl ether, polyoxyethylene polyoxypropylene alkyl ether, glycerin fatty acid partial esters, sorbitan fatty acid partial esters, pentaerythritol fatty acid partial esters, propylene glycol monofatty acid ester, sucrose fatty acid partial esters, polyoxyethylene sorbitan fatty acid partial esters, polyoxyethylene castor oil ether, polyoxyethylene sorbitol fatty acid partial esters, polyethylene glycol fatty acid esters, polyglycerin fatty acid partial esters, polyoxyethylene glycerin fatty acid partial esters, fatty acid diethanolamides, N,N-bis-2-hydroxyalkylamines, polyoxyethylene alkylamine, triethanolamine fatty acid ester, and trialkylamine oxide.

Among these, polyoxyethylene alkyl ethers, polyoxyethylene-polyoxypropylene block copolymers, polyoxyethylene castor oil ether, and the like are preferably used.

In addition, as the surfactant, acetylene glycol-based and acetylene alcohol-based oxyethylene adducts, and fluorine-based, silicone-based anionic or non-ionic surfactants can also be used as well.

These surfactants can be used in combination of two or more kinds thereof. For example, it is preferable to use two or more kinds of anionic surfactants different from each other, or to use an anionic surfactant and a non-ionic surfactant in combination. These compounds are preferably selected and used in consideration of influence on the environment. The amount of the surfactant to be used is not particularly limited, but is preferably in a range of 0.01% by mass to 20% by mass with respect to the total mass of the gum solution.

In addition, from the viewpoint of protecting oil sensitivity of an image area in the lithographic printing plate, the gum solution preferably contains an organic solvent having a boiling point of 130°C or higher. In addition, this kind of organic solvent removes a trace amount of the image recording layer remaining and adhering to a hydrophilic layer of a non-image area, thereby exhibiting an effect of enhancing the hydrophilicity of the non-image area.

Specific examples of the organic solvent having a boiling point of 130°C or higher include, as alcohols, n-hexanol, 2-ethylbutanol, n-heptanol, 2-heptanol, 3-heptanol, 2-octanol, 2-ethylhexanol, 3,5,5-trimethylhexanol, nonanol, n-decanol, undecanol, n-dodecanol, trimethylnonyl alcohol, tetradecanol, cyclohexanol, benzyl alcohol, and tetrahydrofurfuryl alcohol.

Examples of ketones include methyl-n-amyl ketone, methyl-n-hexyl ketone, ethyl-n-butyl ketone, di-n-propyl ketone, diacetone alcohol, and cyclohexanone.

Examples of esters include benzoic acid esters such as n-amyl acetate, isoamyl acetate, methylisoamyl acetate, methoxybutyl acetate, benzyl acetate, ethyl lactate, butyl lactate, n-amyl lactate, methyl benzoate, ethyl benzoate, and benzyl benzoate; phthalic acid diesters such as dimethyl phthalate, diethyl phthalate, dibutyl phthalate, di-2-ethylhexyl phthalate, dioctyl phthalate, dinonyl phthalate, didecyl phthalate, dilauryl phthalate, and butylbenzyl phthalate; aliphatic dibasic acid esters such as dioctyl adipate, butyl glycol adipate, dioctyl azelate, dibutyl sebacate, di(2-ethylhexyl) sebacate, and dioctyl sebacate, epoxidized triglycerides such as epoxidized soybean oil; and phosphoric acid esters such as tricresyl phosphate, trioctyl phosphate, and trischloroethyl phosphate.

Examples of amides include N,N-dimethylformamide, N,N-dimethylacetamide, N-methyl-2-pyrrolidone, N-ethyl-2-pyrrolidone, and N-butyl-2-pyrrolidone.

Examples of polyhydric alcohols and a derivative thereof include ethylene glycol, ethylene glycol monomethyl ether acetate, ethylene glycol monoethyl ether acetate, ethylene glycol butyl ether, ethylene glycol dibutyl ether, ethylene glycol isoamyl ether, ethylene glycol monophenyl ether, ethylene glycol monophenyl ether acetate, ethylene glycol benzyl ether, ethylene glycol monohexyl ether, methoxyethanol, diethylene glycol, diethylene glycol monomethyl ether, diethylene glycol monoethyl ether, diethylene glycol monobutyl ether, diethylene glycol monobutyl ether acetate, diethylene glycol dimethyl ether, diethylene glycol dibutyl ether, diethylene glycol dibutyl ether, triethylene glycol, triethylene glycol monomethyl ether, triethylene glycol monoethyl ether, tetraethylene glycol, propylene glycol, dipropylene glycol, propylene glycol monoethyl ether, propylene glycol monobutyl ether, 1-butoxyethoxy propanol, dipropylene glycol, dipropylene glycol monomethyl ether, dipropylene glycol monoethyl ether, tripropylene glycol monomethyl ether, tripropylene glycol monobutyl ether, butylene glycol, hexylene glycol, octylene glycol, glycerin, diglycerin, trimethylolpropane, glycerin monoacetate, and glycerin triacetate.

Examples of hydrocarbon-based organic solvent include aromatic and aliphatic compounds of petroleum fraction, which has a boiling point of 160°C or higher, and squalane.

The conditions for selecting the organic solvent having a boiling point of 130°C or higher include environmental safety, particularly odor. These solvents may be used alone or in combination of two or more kinds thereof.

The content of the organic solvent having a boiling point of 130°C or higher is preferably in a range of 0.1% by mass to 5.0% by mass and more preferably in a range of 0.3% by mass to 3.0% by mass with respect to the total mass of the gum solution.

In the gum solution, these organic solvents may be solubilized with the surfactant to be a solution type, or may be emulsified and dispersed as an oil phase to be an emulsion type.

In addition, the gum solution used in the gum treatment section, the second gum treatment section, or the like may be used by adding a developer. It is possible to reduce the precipitation of components of the photosensitive layer in the gum solution.

Examples of a method of adding the developer to the gum solution include a method of taking out a developer, which adheres to a plate from a development bath, to the gum treatment section, or manually adding the developer to the gum treatment section, and a method of replenishing a developer by an automatic replenishing device.

The amount of the developer taken out from the development bath to the gum treatment section is preferably in a range of 1 mL/m² to 5 mL/m².

The developer may be directly replenished to the gum treatment section, or in a case where the second gum treatment section is provided, may be replenished, after being added to the second gum treatment section, by flowing from a second gum bath into the gum treatment section. The replenishment amount is preferably in a range of 0.1 mL/m² to 10 mL/m².

The components of the developer to be added may be the same as or different from the developer used in the development section, but are preferably the same.

The amount of the developer to be added to the gum solution is not particularly limited, but from the viewpoint of print stain resistance, is preferably 10% by mass or less with respect to the total mass of the gum solution before addition. In particular, in a case where the amount of the developer to be added to the second gum treatment section is within the above-described range, since the concentration of the gum solution is maintained and protective property of the non-image area is more excellent, scratch stains are further suppressed, and since water retention of the non-image area is more excellent, left stains are further suppressed.

In addition, from the viewpoint of reducing the amount of waste solution, as the developer, a solution having a higher pH, for example, a developer replenisher or a concentrated solution may be used and added in a small amount.

In addition, the pH of the gum solution in a case of adding the developer to the gum solution is not particularly limited, but it is preferable that the pH of the gum solution is lower than the pH of the added developer. Furthermore, from the viewpoint of impressing property, print stain resistance, and fine line reproducibility, the pH of the gum solution in a case of adding the developer to the gum solution is preferably in a range of 2 to 11 and more preferably in a range of 2 to 9. In a case where the pH of the gum solution is within the above-described range, developability is more excellent, and halftone dot reproducibility of 5% or less and fine line reproducibility are more excellent.

### (Method for producing lithographic printing plate)

The method for producing a lithographic printing plate according to an embodiment of the present disclosure is not particularly limited as long as the method exhibits all essential elements of the inventive method as defined by the appended claims, but a method in which a lithographic printing plate precursor is developed with an alkaline developer having a pH of 8.5 to 14 in the development section and subsequently subjected to a gum treatment using a gum solution having a pH of 2 to 6 in the gum treatment section is particularly preferable.

Preferred aspects of the development processing apparatus according to the embodiment of the present disclosure, the developer, the gum solution, the washing solution, and the like used in the method for producing a lithographic printing plate according to the embodiment of the present disclosure are the same as the above-described preferred aspects.

The amount of the washing solution supplied onto the transport roller in the gum treatment section is not particularly limited, but from the viewpoint of halftone dot reproducibility and suppression of unevenness in printing durability of halftone dots of the obtained lithographic printing plate, it is preferable that, in one supply of the washing solution, the supply amount is 50 mL/time or more and is 20% by mass or less with respect to the total mass of the gum solution in the gum treatment section, and it is more preferable that the supply amount is in a range of 50 mL/time to 200 mL/time and is in a range of 1% by mass to 20% by mass with respect to the total mass of the gum solution in the gum treatment section.

In addition, from the viewpoint of halftone dot reproducibility and suppression of unevenness in printing durability of halftone dots of the obtained lithographic printing plate, it is preferable that the concentration of solid contents of gum solution after supplying the washing solution is 50% by mass or less with respect to the concentration of solid contents of gum solution remaining in a nip portion of the transport roller in the gum treatment section. In addition, the lower limit value of the concentration of solid contents of gum solution after supplying the washing solution is 0% by mass.

The concentration of solid contents of gum solution is calculated by collecting the gum solution remaining in the nip portion (for example, between two rollers) of the transport roller in the gum treatment section with a syringe or the like, volatilizing volatile components such as water, and measuring mass before and after volatilization.

The concentration of solid contents of gum solution on the roller before washing can be obtained by the following procedure.

Within 1 minute after stopping the gum treatment, 0.5 cc of gum solution is collected from a meniscus, which is formed by the gum solution and formed on the center in a width direction of the nip portion of the pair of inlet side transport rollers in the gum treatment section, using a micropipette. The gum solution is immediately placed on an aluminum board of 10 cm × 10 cm, and the weight is measured with an electronic balance. The weight of the gum solution is calculated by subtracting the weight of the aluminum board measured in advance. Furthermore, the aluminum board on which the gum solution is placed is put into a drying oven at 80°C and dried, and then the weight is measured with the electronic balance, thereby calculating the weight of solid contents of gum solution and the concentration of solid contents of gum solution on the roller before washing.

Furthermore, after stopping the gum treatment, the roller is washed under the above-described conditions after a predetermined time is elapsed. After completing the washing, the concentration of solid contents of gum solution on the roller after washing is calculated in the same manner as the concentration of solid contents of gum solution on the roller before washing.

Thus, the rate of dilution of the gum component on the roller with the washing water can be calculated.

In addition, with regard to aspects other than the development processing apparatus according to the embodiment of the present disclosure, the developer, the gum solution, and the washing solution in the method for producing a lithographic printing plate according to the embodiment of the present disclosure, reference can be made to a known method for producing a lithographic printing plate.

The method for producing a lithographic printing plate according to the embodiment of the present disclosure preferably includes an exposure step of image-wise exposing a lithographic printing plate precursor to form an exposed area and an unexposed area.

The image exposure of the lithographic printing plate precursor can be performed in conformity with an image exposure operation for a typical lithographic printing plate precursor.

The image exposure is performed by laser exposure through a transparent original picture having a line image, a halftone image, and the like or by laser beam scanning using digital data. The wavelength of a light source is preferably in a range of 700 nm to 1,400 nm. As the light source having a wavelength of 700 nm to 1,400 nm, a solid-state laser or a semiconductor laser that radiates infrared rays is suitable. The output of the infrared laser is preferably 100 mW or greater, the exposure time per one pixel is preferably within 20 µsec, and the irradiation energy quantity is preferably in a range of 10 mJ/cm² to 300 mJ/cm². For the purpose of reducing the exposure time, it is preferable to use a multi-beam laser device. The exposure mechanism may be any of an internal drum system, an external drum system, a flat bed system, and the like. The image exposure can be performed using a plate setter according to a usual method.

The lithographic printing plate obtained from the method for producing a lithographic printing plate according to the embodiment of the present disclosure is suitably used for printing on a recording medium, in which dampening water and printing ink are supplied to the lithographic printing plate, has excellent halftone dot reproducibility in a case of printing, and suppresses the occurrence of unevenness in printing durability of halftone dots.

The printing ink is not particularly limited, and various known inks can be used as desired. In addition, preferred examples of the printing ink include an oily ink or an ultraviolet curable ink (UV ink), and more preferred examples thereof include a UV ink.

In addition, the dampening water is not particularly limited, and a known dampening water can be used.

The recording medium is not particularly limited, and a known recording medium can be used as desired.

### Examples

Hereinafter, the present disclosure will be described in detail with reference to examples, but the present invention is limited by the scope of the claims, only. In the present examples, "%" and "parts" respectively indicate "% by mass" and "parts by mass" unless otherwise specified. In a polymer compound, the molecular weight indicates the weight-average molecular weight (Mw) and the proportion of constitutional units indicates mole percentage unless otherwise specified.

### (Example 1)

The development processing apparatus shown in Fig. 1 was used.

In a case of using, a gum solution was sprayed from each gum solution supplying spray at a discharge rate of 200 mL/min, and the amount of a washing solution supplied from the unit A was 500 mL per washing.

The washing timing in the development processing apparatus was set at predetermined intervals (once every 24 hours) during a standby state and was set at a case where the operation switch of the development processing apparatus was turned off.

In addition, the size of each of the transport rollers 42, 44, and 62 was 60 mm in diameter and 1,350 mm in width.

In addition, the following were used as the lithographic printing plate precursor, the developer, the washing solution, and the gum solution.
Lithographic printing plate precursor: XP-F manufactured by FUJIFILM Corporation (positive lithographic printing plate precursor, 1,030 mm × 800 mm)
Developer: solution (pH = 13) in which XP-D manufactured by FUJIFILM Corporation and ion exchange water were mixed at a mass ratio of 1:8
Developer replenisher: solution (pH = 13) in which XP-DR manufactured by FUJIFILM Corporation and ion exchange water were mixed at a mass ratio of 1:6.5
Washing solution: aqueous solution containing 1,000 ppm of a preservative (BK-3 manufactured by FUJIFILM Corporation)
Gum solution: XP-G manufactured by FUJIFILM Corporation (pH = 4.5)

In addition, as the lithographic printing plate precursor, a lithographic printing plate precursor in which the above-described lithographic printing plate precursor was imagewise exposed by Lotem 400 Quantum imager manufactured by CREO with an energy of 80 mJ/cm² was used.

The exposed image had a solid image, and a flat halftone image of 50% halftone dots of TAFFETA20 (FM screen) manufactured by FUJIFILM Corporation.

### <Evaluation of halftone dot reproducibility and unevenness in printing durability of halftone dots>

Using the above-described development processing apparatus, 10 exposed lithographic printing plate precursors were developed to produce lithographic printing plates, and the operation switch of the development processing apparatus was once turned off. After 12 hours, the operation switch of the development processing apparatus was turned on again, and one exposed lithographic printing plate precursor was developed to produce a lithographic printing plate. The washing was performed at a case where the operation switch of the development processing apparatus was turned off and at a case where the operation switch of the development processing apparatus was turned on.

The following evaluation was carried out using the lithographic printing plate produced last.

### -Evaluation of halftone dot reproducibility-

With regard to the lithographic printing plate produced before turning off the operation switch and the lithographic printing plate produced after turning on the operation switch again, the halftone dot reproducibility on the plate was visually evaluated. In both cases, no unevenness was observed in the flat halftone image of 50% halftone dots.

### -Evaluation of unevenness in printing durability of halftone dots-

The lithographic printing plate, which was used for the evaluation of halftone dot reproducibility, was attached to a plate cylinder of a printing press LITHRONE26 (manufactured by KOMORI Corporation). Using dampening water in which the volume ratio of Ecolity-2 (manufactured by FUJIFILM Corporation) to tap water was 2/98 and using Values-G(N) BLACK INK (manufactured by DIC Graphics Corporation), printing was started by supplying the dampening water and the ink according to a standard automatic printing start method with LITHRONE26, and then printing was performed on Tokubishi Art (ream weight: 76.5 kg) paper at a printing speed of 10,000 sheets per hour.

With an increase in number of printed sheets, the ink density in a printed article was decreased since an image recording layer was gradually worn out. In a case where the flat halftone image on the printed article after printing 20,000 sheets using the lithographic printing plate produced before turning off the operation switch and the lithographic printing plate produced after turning on the operation switch again was visually evaluated whether unevenness occurs in a direction perpendicular to a development processing direction, no unevenness was observed in the flat halftone image of 50% halftone dots.

As described above, in Example 1, a lithographic printing plate having excellent halftone dot reproducibility in a case of printing, and suppressing the occurrence of unevenness in printing durability of halftone dots was obtained.

### (Example 2)

Evaluation was performed in the same manner as in Example 1, except that the developer to be used was changed to the solution (pH = 13) in which XP-DR manufactured by FUJIFILM Corporation and ion exchange water were mixed at a mass ratio of 1:6.5.

Also in Example 2, a lithographic printing plate having excellent halftone dot reproducibility in a case of printing, and suppressing the occurrence of unevenness in printing durability of halftone dots was obtained.

### (Comparative Example 1)

A lithographic printing plate was produced in the same manner as in Example 1, except that a development processing apparatus in which the unit A of supplying the washing solution was removed from the development processing apparatus shown in Fig. 1, and the solution supply to the unit A was stopped was used.

With regard to the lithographic printing plate produced before turning off the operation switch and the lithographic printing plate produced after turning on the operation switch again, the halftone dot reproducibility on the plate was visually evaluated. In the former, no unevenness was observed in the flat halftone image of 50% halftone dots. On the other hand, in the latter, in the flat halftone image of 50% halftone dots on the plate, a plurality of dark halftone dots were observed in a region of approximately 3 mm to 8 mm in width, in the direction perpendicular to the development processing direction.

In addition, in a case where the flat halftone image on the printed article after printing 20,000 sheets using the lithographic printing plate produced before turning off the operation switch and the lithographic printing plate produced after turning on the operation switch again was visually evaluated, in the latter, in the flat halftone image of 50% halftone dots on the plate, a plurality of dark halftone dots were observed in a region of approximately 5 mm to 10 mm in width, in the direction perpendicular to the development processing direction, which was more noticeable than the visual evaluation on the plate.

From the above-described results, with the development processing apparatus provided with the unit A of supplying the washing solution, which is the development processing apparatus according to the embodiment of the present disclosure, a lithographic printing plate which has excellent halftone dot reproducibility in a case of printing and suppresses occurrence of unevenness in printing durability of halftone dots is obtained.

### Explanation of References

2: development processing apparatus for producing lithographic printing plate (development processing apparatus)
4: development section
6: gum treatment section
8: second gum treatment section
10: drying section
12: transport roller
14: wall assembly
16: transport roller
18: developer
20: developer exhausting port
22: developer exhausting unit
24: transport belt
26: developer supplying unit
28: transport roller
30: brush roller
32: transport roller
34: transport guide board
36: transport guide board holding member
38: transport roller
40: cover
42: transport roller
44: transport roller
46: gum solution supplying spray
48: unit dropping washing solution
50: washing solution spreading member
52: washing solution supplying unit fixing part
54: backflow preventing member
56: gum solution
58: gum solution exhausting port
59: gum solution exhausting unit
60: gum treatment section bottom part
62: transport roller
64: gum solution
66: gum solution exhausting port
68: gum solution supplying unit
70: support roller
72: drying unit
74: transport roller
76: drying unit
78: transport roller
80: lithographic printing plate outlet
d: difference between liquid level of gum solution 56 in gum treatment section 6 and liquid level of gum solution 64 in second gum treatment section 8

## Claims

1. A development processing apparatus (2) for producing a lithographic printing plate, comprising:
a development section (4);
a gum treatment section (6) continuous to the development section (4);
a second gum treatment section (8) continuous to the gum treatment section (6),
wherein the gum treatment section (6) has a transport roller (42), a unit A (48) supplying a washing solution to the transport roller (42), and a gum solution exhausting port (66), and
wherein the second gum treatment section (8) has a gum solution supplying unit (68) for supplying gum solution to the gum treatment section (6),
wherein the unit A (48) supplying the washing solution is set to supply the washing solution on the transport roller (42) in at least one point in time selected from the group consisting of a start of operation of the development processing apparatus (2), a time from an end of development processing to a start of next development processing, and an end of operation of the development processing apparatus (2).

2. The development processing apparatus (2) according to claim 1,
wherein the unit A (48) is a unit installed above the transport roller (42) in the gum treatment section (6) and dropping the washing solution onto the transport roller (42).

3. The development processing apparatus (2) according to claim 1 or 2,
wherein a washing solution spreading member (50), which spreads the washing solution dropped on the transport roller (42) onto the transport roller (42), is installed on the transport roller (42) in the gum treatment section (6).

4. The development processing apparatus (2) according to claim 3,
wherein the washing solution spreading member (50) is installed in contact with an outer periphery of an upper roller of the transport roller (42) on a development section (4) side from a position where the washing solution is dropped on the transport roller (42), and above a center of an axis of the upper roller.

5. The development processing apparatus (2) according to any one of claims 1 to 4,
wherein a backflow preventing member (54), which prevents a gum solution from mixing with a developer (18) in the development section (4), is installed to the transport roller (42) in the gum treatment section (6).

6. The development processing apparatus (2) according to any one of claims 1 to 5,
wherein the gum treatment section (6) has two pairs of transport rollers (42, 44) including the transport roller (42), and
in the gum treatment section, between one pair of the transport rollers (42, 44) on an upstream side in a transport direction and one pair of the transport rollers (42, 44) on a downstream side in the transport direction, a unit, which supplies a gum solution to a plate surface of a developed lithographic printing plate directly or through the one pair of the transport rollers (42, 44) on the upstream side in the transport direction, is provided.

7. The development processing apparatus (2) according to claim 1 or 2,
wherein the apparatus is configured such that, in use, the liquid level of the gum solution (64) in the second gum treatment section (8) is higher than the liquid level of the gum solution (56) in the gum treatment section (6).

8. The development processing apparatus (2) according to any one of claim 1 to 7,
wherein the unit A (48) is fixed by a washing solution supplying unit fixing part (52) to the development processing apparatus (2), and
the shape of the washing solution supplying unit fixing part (52) is a shape in which a cross-sectional shape covers at least three sides of the unit A (48).

9. A method for producing a lithographic printing plate, the method comprising:
developing a lithographic printing plate precursor with an alkaline developer having a pH of 8.5 to 14 in the development section by using the development processing apparatus (2) according to any one of claims 1 to 8; and
subsequently performing a gum treatment using a gum solution in the gum treatment section (6).

10. The method for producing a lithographic printing plate according to claim 9,
wherein a washing solution to be supplied to the transport roller (42) in the gum treatment section (6) is an aqueous solution containing a preservative.

11. The method for producing a lithographic printing plate according to claim 9 or 10,
wherein an amount of the washing solution supplied onto the transport roller (42) in the gum treatment section is 50 mL/time or more, and is 20% by mass or less with respect to a total mass of the gum solution in the gum treatment section (6).

12. The method for producing a lithographic printing plate according to any one of claims 9 to 11,
wherein a concentration of solid contents of gum solution after supplying the washing solution is 50% by mass or less with respect to a concentration of solid contents of gum solution remaining in a nip portion of the transport roller (42) in the gum treatment section (6).

## Patentansprüche

1. Entwicklungsverarbeitungsvorrichtung (2) zur Herstellung einer lithographischen Druckplatte, umfassend:
einen Entwicklungsabschnitt (4);
einen Gummibehandlungsabschnitt (6), der sich an den Entwicklungsabschnitt (4) anschließt;
einen zweiten Gummibehandlungsabschnitt (8), der sich an den Gummibehandlungsabschnitt (6) anschließt,
wobei der Gummibehandlungsabschnitt (6) eine Transportwalze (42), eine Einheit A (48), die der Transportwalze (42) eine Waschlösung zuführt, und einen Gummilösungsauslassanschluss (66) aufweist, und
wobei der zweite Gummibehandlungsabschnitt (8) eine Gummilösungszuführeinheit (68) aufweist, um dem Gummibehandlungsabschnitt (6) Gummilösung zuzuführen,
wobei die Einheit A (48), die die Waschlösung zuführt, eingestellt ist, um die Waschlösung auf die Transportwalze (42) zu mindestens einem Zeitpunkt zuzuführen, der aus der Gruppe ausgewählt ist, die aus einem Beginn des Betriebs der Entwicklungsverarbeitungsvorrichtung (2), einer Zeit von einem Ende der Entwicklungsverarbeitung bis zu einem Beginn der nächsten Entwicklungsverarbeitung und einem Ende des Betriebs der Entwicklungsverarbeitungsvorrichtung (2) besteht.

2. Entwicklungsverarbeitungsvorrichtung (2) nach Anspruch 1,
wobei die Einheit A (48) eine Einheit ist, die oberhalb der Transportwalze (42) in dem Gummibehandlungsabschnitt (6) installiert ist, und die Waschlösung auf die Transportwalze (42) tropft.

3. Entwicklungsverarbeitungsvorrichtung (2) nach Anspruch 1 oder 2,
wobei an der Transportwalze (42) in dem Gummibehandlungsabschnitt (6) ein Waschlösungsverteilungselement (50) installiert ist, das die auf die Transportwalze (42) getropfte Waschlösung auf die Transportwalze (42) verteilt.

4. Entwicklungsverarbeitungsvorrichtung (2) nach Anspruch 3,
wobei das Waschlösungsverteilungselement (50) in Kontakt mit einem Außenumfang einer oberen Walze der Transportwalze (42) auf einer Seite des Entwicklungsabschnitts (4) von einer Position aus, an der die Waschlösung auf die Transportwalze (42) getropft wird, und oberhalb einer Mitte einer Achse der oberen Walze installiert ist.

5. Entwicklungsverarbeitungsvorrichtung (2) nach einem der Ansprüche 1 bis 4,
wobei ein Rückflussverhinderungselement (54), das verhindert, dass sich eine Gummilösung mit einem Entwickler (18) in dem Entwicklungsabschnitt (4) vermischt, an der Transportwalze (42) in dem Gummibehandlungsabschnitt (6) installiert ist.

6. Entwicklungsverarbeitungsvorrichtung (2) nach einem der Ansprüche 1 bis 5,
wobei der Gummibehandlungsabschnitt (6) zwei Paare von Transportwalzen (42, 44) aufweist, die die Transportwalze (42) einschließen, und
in dem Gummibehandlungsabschnitt zwischen einem Paar der Transportwalzen (42, 44) auf einer stromaufwärtigen Seite in einer Transportrichtung und einem Paar der Transportwalzen (42, 44) auf einer stromabwärtigen Seite in der Transportrichtung, eine Einheit, die eine Gummilösung direkt oder durch das eine Paar der Transportwalzen (42, 44) auf der in Transportrichtung stromaufwärtigen Seite auf eine Plattenoberfläche einer entwickelten lithografischen Druckplatte zuführt, bereitgestellt ist.

7. Entwicklungsverarbeitungsvorrichtung (2) nach Anspruch 1 oder 2,
wobei die Vorrichtung so konfiguriert ist, dass bei Verwendung der Flüssigkeitsstand der Gummilösung (64) in dem zweiten Gummibehandlungsabschnitt (8) höher ist als der Flüssigkeitsstand der Gummilösung (56) in dem Gummibehandlungsabschnitt (6).

8. Entwicklungsverarbeitungsvorrichtung (2) nach einem der Ansprüche 1 bis 7,
wobei die Einheit A (48) durch ein Befestigungsteil (52) der Waschlösungszuführeinheit an der Entwicklungsverarbeitungsvorrichtung (2) befestigt ist, und
die Form des Befestigungsteils (52) der Waschlösungszuführeinheit eine Form ist, bei der eine Querschnittsform mindestens drei Seiten der Einheit A (48) abdeckt.

9. Verfahren zur Herstellung einer lithographischen Druckplatte, wobei das Verfahren umfasst:
Entwickeln eines lithografischen Druckplattenvorläufers mit einem alkalischen Entwickler, der einen pH-Wert von 8,5 bis 14 in dem Entwicklungsabschnitt aufweist, unter Verwendung der Entwicklungsverarbeitungsvorrichtung (2) nach einem der Ansprüche 1 bis 8; und
anschließendes Durchführen einer Gummibehandlung unter Verwendung einer Gummilösung in dem Gummibehandlungsabschnitt (6).

10. Verfahren zur Herstellung einer lithografischen Druckplatte nach Anspruch 9,
wobei eine Waschlösung, die der Transportwalze (42) in dem Gummibehandlungsabschnitt (6) zugeführt werden soll, eine wässrige Lösung ist, die ein Konservierungsmittel enthält.

11. Verfahren zur Herstellung einer lithografischen Druckplatte nach Anspruch 9 oder 10,
wobei eine Menge der Waschlösung, die der Transportwalze (42) in dem Gummibehandlungsabschnitt zugeführt wird, 50 ml/Zeit oder mehr beträgt, und 20 Massen-% oder weniger in Bezug auf eine Gesamtmasse der Gummilösung in dem Gummibehandlungsabschnitt (6) beträgt.

12. Verfahren zur Herstellung einer lithographischen Druckplatte nach einem der Ansprüche 9 bis 11,
wobei eine Konzentration des Feststoffgehalts der Gummilösung nach dem Zuführen der Waschlösung in Bezug auf eine Konzentration des Feststoffgehalts der Gummilösung, die in einem Walzenspaltabschnitt der Transportwalze (42) in dem Gummibehandlungsabschnitt (6) verbleibt, 50 Massen-% oder weniger beträgt.

## Revendications

1. Appareil (2) de traitement de développement pour la production d'une plaque d'impression lithographique, comprenant :
une section de développement (4) ;
une section (6) de traitement de gomme en continuité avec la section de développement (4) ;
une seconde section (8) de traitement de gomme en continuité avec la section (6) de traitement de gomme,
dans lequel la section (6) de traitement de gomme présente un rouleau de transport (42), une unité A (48) fournissant une solution de lavage au rouleau de transport (42), et un orifice (66) d'évacuation de solution de gomme, et
dans lequel la seconde section (8) de traitement de gomme présente une unité d'alimentation en solution de gomme (68) pour alimenter la section (6) de traitement de gomme en solution de gomme,
dans lequel l'unité A (48) fournissant la solution de lavage est réglée pour fournir la solution de lavage sur le rouleau de transport (42) à au moins un moment choisi dans le groupe constitué par un début de fonctionnement de l'appareil (2) de traitement de développement, un temps entre la fin du traitement de développement et le début du traitement de développement suivant, et une fin de fonctionnement de l'appareil (2) de traitement de développement.

2. Appareil (2) de traitement de développement selon la revendication 1,
dans lequel l'unité A (48) est une unité installée au-dessus du rouleau de transport (42) dans la section (6) de traitement de gomme et qui fait tomber la solution de lavage sur le rouleau de transport (42).

3. Appareil (2) de traitement de développement selon la revendication 1 ou la revendication 2,
dans lequel un élément d'étalement de solution de lavage (50), qui étale la solution de lavage tombée sur le rouleau de transport (42) sur le rouleau de transport (42), est installé sur le rouleau de transport (42) dans la section (6) de traitement de gomme.

4. Appareil (2) de traitement de développement selon la revendication 3,
dans lequel l'élément d'étalement de solution de lavage (50) est installé en contact avec une périphérie externe d'un rouleau supérieur du rouleau de transport (42) sur un côté section de développement (4) par rapport à une position où la solution de lavage tombe sur le rouleau de transport (42), et au-dessus d'un centre d'un axe du rouleau supérieur.

5. Appareil (2) de traitement de développement selon l'une des revendications 1 à 4,
dans lequel un élément empêchant le reflux (54), qui empêche une solution de gomme de se mélanger avec un révélateur (18) dans la section de développement (4), est installé sur le rouleau de transport (42) dans la section (6) de traitement de gomme.

6. Appareil (2) de traitement de développement selon l'une quelconque des revendications 1 à 5,
dans lequel la section (6) de traitement de gomme présente deux paires de rouleaux de transport (42, 44) incluant le rouleau de transport (42), et
dans la section de traitement de gomme, entre une paire de rouleaux de transport (42, 44) du côté amont dans une direction de transport et une paire de rouleaux de transport (42, 44) du côté aval dans la direction de transport, une unité, qui fournit une solution de gomme à une surface de plaque d'une plaque d'impression lithographique développée, directement ou à travers une paire de rouleaux de transport (42, 44) du côté amont dans la direction de transport, est fournie.

7. Appareil (2) de traitement de développement selon la revendication 1 ou la revendication 2,
dans lequel l'appareil est conçu de telle sorte que, lors de l'utilisation, le niveau de liquide de la solution de gomme (64) dans la seconde section (8) de traitement de gomme est plus élevé que le niveau de liquide de la solution de gomme (56) dans la section (6) de traitement de gomme.

8. Appareil (2) de traitement de développement selon l'une quelconque des revendications 1 à 7,
dans lequel l'unité A (48) est fixée à l'appareil (2) de traitement de développement par une pièce de fixation (52) d'unité d'alimentation en solution de lavage, et
la forme de la pièce de fixation (52) d'unité d'alimentation en solution de lavage est une forme dans laquelle une section transversale couvre au moins trois côtés de l'unité A (48).

9. Procédé de production d'une plaque d'impression lithographique, comprenant :
le fait de développer un précurseur de plaque d'impression lithographique avec un révélateur alcalin présentant un pH de 8,5 à 14 dans la section de développement en utilisant l'appareil (2) de traitement de développement selon l'une quelconque des revendications 1 à 8 ; et
le fait de mettre ensuite en oeuvre un traitement de gomme en utilisant une solution de gomme dans la section (6) de traitement de gomme.

10. Procédé de fabrication d'une plaque d'impression lithographique selon la revendication 9,
dans lequel une solution de lavage à fournir au rouleau de transport (42) dans la section (6) de traitement de gomme est une solution aqueuse contenant un conservateur.

11. Procédé de production d'une plaque d'impression lithographique selon la revendication 9 ou la revendication 10,
dans lequel une quantité de solution de lavage fournie au rouleau de transport (42) dans la section de traitement de gomme est de 50 mL/temps ou plus, et est de 20 % en masse ou moins par rapport à une masse totale de la solution de gomme dans la section (6) de traitement de gomme.

12. Procédé de production d'une plaque d'impression lithographique selon l'une quelconque des revendications 9 à 11,
dans lequel une concentration en contenus solides de la solution de gomme après la fourniture de la solution de lavage est de 50 % en masse ou moins par rapport à une concentration en contenus solides de la solution de gomme restant dans une partie de pincement du rouleau de transport (42) dans la section (6) de traitement de gomme.
